Europäisches Patentamt

(19) European Patent Office

Office européen des brevets

(11) Publication number: **0 229 159 B1**

(12) **EUROPEAN PATENT SPECIFICATION**

(45) Date of publication of patent specification :
**17.04.91 Bulletin 91/16**

(51) Int. Cl.⁵ : **B32B 31/12,** B32B 31/28,
**B23K 26/08**

(21) Application number : **86904544.3**

(22) Date of filing : **18.06.86**

(86) International application number :
**PCT/US86/01328**

(87) International publication number :
**WO 86/07568 31.12.86 Gazette 86/28**

(54) **METHOD FOR PRODUCING ENHANCED BONDS BETWEEN SURFACES AND ARTICLES PRODUCED BY THE METHOD.**

(30) Priority : **18.06.85 US 746170**

(43) Date of publication of application :
**22.07.87 Bulletin 87/30**

(45) Publication of the grant of the patent :
**17.04.91 Bulletin 91/16**

(84) Designated Contracting States :
**DE FR GB IT NL SE**

(56) References cited :
**DE-A- 2 035 490
US-A- 3 111 424
US-A- 3 193 424
US-A- 3 560 291
US-A- 3 600 289
US-A- 3 981 762
US-A- 4 063 063
US-A- 4 223 074
US-A- 4 288 678
US-A- 4 368 080
US-A- 4 377 736**

(56) References cited :
**US-A- 4 544 442
PATENT ABSTRACTS OF JAPAN, vol. 8, no.
195 (M-323)[1632], 7th September 1984; &
JP-A-59 85 392 (NIPPON AVIONICS K.K.) 17-
05-1984**

(73) Proprietor : **THE DOW CHEMICAL COMPANY
2030 Dow Center Abbott Road P.O. Box 1967
Midland Michigan 48640-1967 (US)**

(72) Inventor : **VOLKMANN, Curtis, L.
1901 Eastlawn Drive, Apt. A-11
Midland, MI 48640 (US)**
Inventor : **KESTER, John, J.
5401 Nurmi
Midland, MI 48640 (US)**
Inventor : **STEVENS, Gregory, A.
5001 Oakridge Drive
Midland, MI 48640 (US)**

(74) Representative : **Sternagel, Hans-Günther, Dr.
et al
Patentanwälte Dr. Michael Hann Dr. H.-G.
Sternagel Sander Aue 30
W-5060 Bergisch Gladbach 2 (DE)**

EP 0 229 159 B1

## Description

The present invention relates to a method for making an improved adhesive bond.

A need has long existed for a method of enhancing the adhesive bonding characteristics of various materials. This need has extended to enhancing the bonding characteristics of materials which are essentially clean surfaces, e.g., solvent cleaned surfaces, as well as enhancing the bonding characteristics of contaminated surfaces, e.g., surfaces covered with a protective coating such as a wax or oil coated surface. These needs have developed for example out of the automotive and aircraft industries' dissatisfaction with current surface treatment techniques and bonding results.

An elegant explanation of material treatment using energy beams comprising laser beams is contained in US-A-4,122,240 granted to Banas et al. Figure 1 therein shows a plot of absorbed power density versus interaction time. At relatively low absorbed power density applied for relatively long times, materials can be heated to appreciable depths without melting the surface and thus can be subjected to "transformation hardening." At very high absorbed power density applied for extremely short periods of time to a surface coated with a thin layer of preferably black paint (which enhances absorption of the laser beam) surface vaporization of the paint is so violent that a shock wave of sufficient amplitude moves through the material that can result in "shock hardening" (see US-A-4,401,477 to Clauer et al.). At mid-absorbed power density applied for intermediate time periods, the irradiated material can be vaporized to a significant depth for "hole drilling" applications. At lower power density applied for longer time periods, the material can be melted to significant depths for "deep penetration welding." Using approximately the same absorbed power density as in "deep penetration welding," but for shorter periods of time, Banas et al. achieved "skin melting." In skin melting a thin layer of the material irradiated is melted but not vaporized and then rapidly self-cooled.

Langen et al. in US-A-4,368,080 apply 0.5 to 16 joules/cm$^2$ per pulse and a pulse time of from 1 to 100 microseconds to clean rust from metallic objects prior to painting. The power density used by Langen et al. is relatively low to prevent melting or vaporization of the parent metal, but high enough to vaporize the rust or to convert the rust to a form not detrimental to subsequent paint performance.

In JP-A-54-26509 of Iuchi et al. a laser is used to remove oil from steel plates prior to painting. The oil is compounded with light absorbing chemicals to improve the efficiency of conversion of the light energy into heating the oil film and only the oil is vaporized, not the underlying steel. In JP-B- 81,116,867 zinc galvanized steel sheets are polished to remove the zinc coating, irradiated with a laser beam to remove residual zinc, phosphate treated and then painted.

From JP-A-59-85392 a joining method of metal to metal or to nonmetal is known wherein the synergistic effect of an anchoring effect and a chemical bonding force by irradiating a laser beam onto the metallic surface is used. The laser beam forms burrs on the surface by melting and scattering. An adhesive agent is used to join the surface with an adhesing material. The burrs formed by laser beam treatment are spaced distinct burrs.

DD-B-211,801 claims a process for the modification of surface properties of semi-finished products and molded materials made of olefin copolymers. Examples of the process use ionizing radiation, such as corona discharge and energy beams from an electron accelerator, to heat the surface to a temperature between 340 and 410°K. Other forms of ionizing radiation are suggested without examples, such as ultraviolet, x-ray, gamma or laser radiation and particle radiation such as alpha or beta radiation. Improvement of the adhesiveness, printability, metallizability and varnishability is taught in this patent.

It is the object of the invention to provide a method for specific surface modification by a laser beam to enhance bonding characteristics using an adhesive to bond together at least two surfaces which are enhanced relatively comparable to known treated surfaces.

This object is attained by a selection of specific treatment conditions resulting in a method for enhancing the bonding characteristics of an adhesive between two surfaces wherein one of them is a metal surface by modifying at least the metal surface with an energy beam generated by a pulsed laser to generate a roughened surface having load-bearing structures characterized in that the energy beam has a pulse time between 1 and 10 000 ns and the energy density is between 0.05 and 100 Joules/cm$^2$ per pulse to melt and vaporize the surface and to control the depth of any melting or charring of the materials.

The object is also attained by an article comprising an adhesive bond between at least two surfaces of said article prepared by the method according to the present invention as defined in the claims.

In many cases, enhanced bonding characteristics are also shown to be achieved relative to a comparable solvent washed surface or surfaces. The term "enhanced bonding characteristics" refers to a bond having at least one of the following enhanced properties : at least a 20 percent stronger bond as demonstrated by a standard lap shear test ; a more durable bond upon exposure to a sodium chloride solution/high humidity environment as demonstrated using the durability/lap shear test of Example 4 ; a more durable bond upon exposure to moisture as demonstrated by at least a 25 percent shorter crack extension in a modified standard crack extension wedge test ; a stronger bond as demonstrated by at least a 25 percent shorter initial crack in a modified standard wedge test ; at least a 25 percent longer time of immersion in a boiling water bath before debonding in the test of Example 29 ; at least a 20 percent higher pull strength as demonstrated by the ASTM 1876-72 peel test ; at least a 20 percent higher impact strength as demonstrated by a modified ASTM D-256-81 impact test ; at least a 20 percent higher torque strength using the torque test of Example 30 ; or at least a 25 percent reduction in the area of bond failure at the interface between the adhesive and the bonded surface in any of the tests above with a commensurate increase in failure within the adhesive itself or in the bonded material.

Prior techniques for enhancing the bonding characteristics of materials include sandblasting, shot peening, brushing, pickling with acid, anodizing and washing with solvents, see for example, "Adhesives Technology Handbook," A. H. Landrock, 1985, Noyes Publications, ISBN 0-8155-1040-3. All of these techniques have undesirable features such as waste disposal of spent chemicals. Nevertheless, surface treatment usually results in enhanced bondability. For example, galvanized steel sheets formed into automotive door panels are generally coated with a lubricant prior to forming to extend forming die life and to preserve the surface finish of the panel. However, before the panel can be fastened to other parts with an adhesive, the lubricant usually needs to be removed from the panel, e.g., by washing with a solvent, for yet improved bondability. Often, even better bondability can be obtained by additionally roughening or etching the panel surface to be bonded by sandblasting and/or chemical treatment, such as a phosphate treatment. The method of the present invention cleans the surface of a material and also vaposizes and melts the material thus modifying the surface, said modified surface being suitable for adhesion purposes.

Terms

The term "magnesium-containing material" means (1) magnesium or (2) alloys having magnesium as the predominant component.

The term "aluminum-containing material" means (1) aluminum or (2) alloys having aluminum as the predominant component.

The term "copper-containing material" means (1) copper or (2) alloys having copper as the predominant component.

The term "titanium-containing material" means (1) titanium or (2) alloys having titanium as the predominant component.

The term "coact" means the adhesive intimately associates with the treated surface chemistry and/or topography. The chemical association can include various chemical bonding phenomena and surface wetting phenomena. The topographical association can include load transfer between the adhesive and the surface.

The term "stainless steel" refers to steel alloys having greater than 10 percent chromium.

The term "galvanized steel" refers to an alloy of iron which has been coated with a layer of zinc, cadmium or other similarly effective metal or metals in controlling the rate of corrosion of the steel itself.

The term "energy beam" refers to an energy beam generated by a pulsed laser effective to modify the surface of a material.

The term "material" relates to a solid substance such as a metal, an alloy of metal, a metal composite, a metal laminate, a polymer, a polymer composite such as fiber reinforced polymer and composites comprising metals and polymers, as well as inorganic solids such as ceramics and semiconductors.

Modified surfaces having enhanced bonding characteristics have been observed to have one or more of the following surface modification effects : (a) the vaporization off of the surface of any oil, wax, mold release agent or other such organic compound to produce a surface equivalent to a solvent washed surface ; (b) altering the surface of a metal or an inorganic material with the energy beam to produce a diminishment of surface carbon in excess of effect (a) above of at least 20 percent after said altering step as measured by x-ray photoelectron spectroscopy ; (c) altering the surface of a metal with the energy beam to vaporize at least 20 percent of the native metal oxide on the surface as measured by x-ray photoelectron spectroscopy ; (d) heating the surface with an energy beam to not only melt the surface but also to vaporize it ; (e), altering the surface with an energy beam to generate a roughened surface thereby generating load-bearing structures ; (f) heating the surface to vaporize inorganic chemicals from the surface as measured by x-ray photoelectron spectroscopy ; or (g) altering the alloy composition of the surface as measured by x-ray photoelectron spectroscopy.

The energy beam source is a pulsed laser and the specific energy density per pulse at the surface to be treated is coordinated with the pulse time of the laser as to cited in claim 1.

Materials beneficially bonded to a given metal surface by the method of the invention include polymers, metals and inorganic materials such as glass.

## Brief Description of The Drawings

Figure 1 shows an apparatus useful for the method of the invention.

Figure 2 shows photomicrographs of laser treated aluminum of Example 9.

Figure 3 shows photomicrographs of laser treated titanium of Example 12.

Figure 4 shows photomicrographs of laser treated silicone rubber of comparative Example 19.

Figure 5 shows photomicrographs of laser treated tin of Example 20.

Figure 6 shows photomicrographs of laser treated graphite fiber reinforced epoxy composite of comparative Example 21.

Figure 7 shows photomicrographs of laser treated cold rolled steel of Example 22.

Figure 8 shows photomicrographs of laser treated copper of Example 23.

Figure 9 shows photomicrographs of laser treated molybdenum of Example 24.

Figure 10 shows photomicrographs of laser treated tungsten of Example 25.

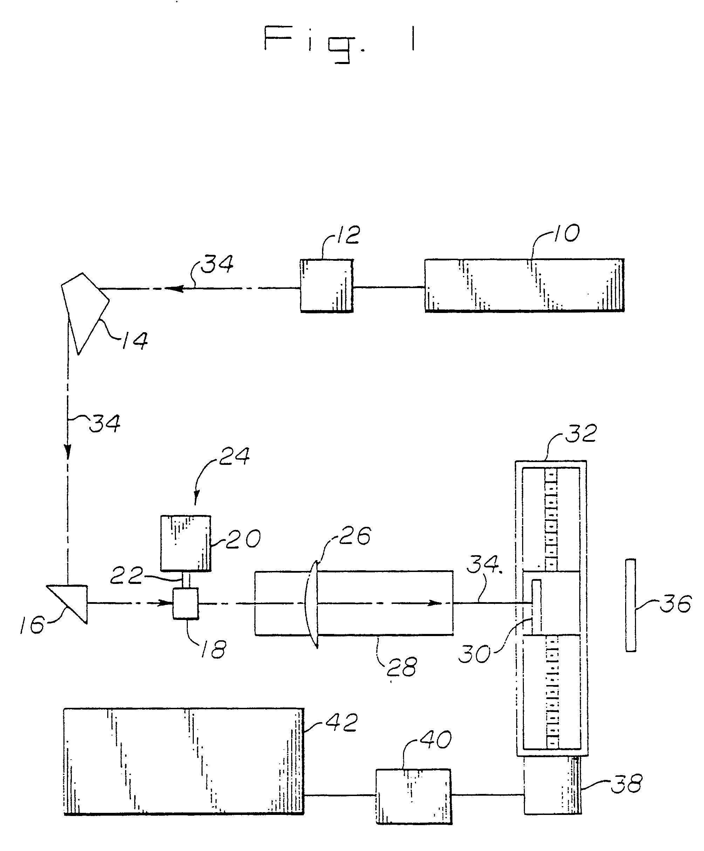

An apparatus useful for modifying surfaces to be bonded according to the method of the invention is typically illustrated in Figure 1 and involves a laser 10 and means 14, 16 and 26 for guiding the beam from the laser to the surface of the object to be treated. A preferred laser 10 is a Q-switched Nd : YAG laser, but other lasers which are preferred include gas lasers, $CO_2$ lasers, and excimer lasers. The Kirk-Othmer "Encyclopedia of Chemical Technology," Third Edition, Volume 154, pages 42-81, John Wiley & Sons, New York (1979), describes various types of lasers and their uses. The apparatus of the invention may also comprise one or more lasers or a laser with beam splitting means adapted for the purposes of the invention.

The beam 34 issuing from laser 10 can be altered by a harmonic generator 12 capable of reducing the wavelength of the beam proportional to a selected integral factor, and optical components, such as a prism 14 to spacially separate differing frequencies of the laser beam, a right-angle prism 16, and a preferred cylindrical focusing lens 26 which focuses the laser beam onto a surface to be treated 30 and results in a generally elliptical shaped area of surface treatment at any one time. The length of said ellipse is determined by the diameter of the laser beam and can be made longer by placing a diverging lens, not shown, in the laser beam 34 as is well known in the art. The dotted line 34 between laser 10 and lens 26 can further represent an optical fiber for directing the beam 34 at the surface to be treated.

A power meter 24 can be disposed between the right-angle prism 16 and the focusing lens 26. The power meter essentially has two parts, a detector head 18 integrally connected by means 22 with a conventional analog readout meter 20. The detector head 18 can be placed in the path of the laser beam to detect the average power of the laser beam.

The cylindrical focusing lens 26 is disposed on a translation stage 28. The translation stage 28 includes a track for moving the lens 26 parallel to the path of the beam to focus and defocus the beam at the sample surface 30 to be treated. The translation stage 28 can be manually operated or operated by robotic means or by a motor.

The sample to be treated 30 is disposed on a sample translation stage 32. The sample surface 30 is moved on the translation stage 32 relative to the beam 34. Preferably, the sample surface 30 is moved perpendicular to the beam 34. The translation stage 32 can be operated by a stepping motor 38 or, alternatively, by a robotic means or by manual means (not shown). Preferably the translation stage 32 is a controlled X-Y translational stage or a combination translation stage-rotating wheel. Such items are easily available commercially, for example, from Velmex Company in Bloomfield, New York. Other means of moving the energy beam relative to the surface to be treated can include optical fibers attached to robot arms that have 2-6 degrees axis of freedom or industrial grade X-Y-Z gantry style platforms. It is convenient to control translation stage 32 with a driver 40 which in turn is operated by a computer 42. The computer 42 can easily control the number of pulses per area or the treatment duration when using a continuous wave laserx on the surface 30 and the amount of overlap between successive areas treated may be easily regulated. As long as the energy density for treating the surface is maintained, the relative movement between the laser beam path and the surface to be treated can be as fast as possible. Preferably, each area treated overlaps at least somewhat with the area treated previously. In many embodiments of the invention where there is a visible change in the surface resulting from the laser treatment, it is preferable that there is an overlap of the visibly affected areas from those areas previously treated. In the case of polymer materials, it is generally believed that the depth of apparent vaporization of the polymer is preferably deep enough to (a) remove any mold release agents, (b) roughen the surface, or (c) expose the fibers which can then beneficially interlock with the applied adhesive. Once the sample 30 has passed through the beam 34, a beam block 36 can be used to trap the beam 34. The invention can also incorporate more than one energy beam, e.g., two or more lasers.

The energy beam or beams can be site-specific, that is, focused on a selected area of a surface, such as a metal surface with a high degree of accuracy to insure that the beams do not affect the appearance and/or other characteristics of neighboring surface areas, namely, of areas which do not require any treatment or whose treatment is already completed. The amount of energy transferred to an area of surface may be controlled by focusing or defocusing the energy beam, controlling the exposure time of the beam and adjusting the output power of the energy beam source. Any vaporized material may be easily exhausted from the treatment area using conventional exhaust, so as not to affect the health and/or comfort of the attendants and not to contribute to the pollution of the surrounding atmosphere.

The energy beam source must satisfy certain criteria. The first criterion is that the energy beam source must be capable of producing an extremely high energy density at the surface to be treated. For this invention, the critical parameter is absorbed energy rather than incident energy. However, absorbed energy is difficult to quantify and for the case where a pulsed laser is used as the beam source, the proportion of energy absorbed varies widely, for example, with differences in the material to be treated and the condition of the surface to be treated. The second criterion is that the absorbed energy must be converted into sufficient thermal energy to vaporize and to melt a surface layer of said. The third criterion is that the energy beam applied to any specific area of the material must be applied for a relatively short time to control the depth of any melting or charring of the material. This criteria must be observed to prevent melt through or burn through of the material to be treated.

Using a pulsed laser or a plurality of pulsed lasers, the exposure time of the laser onto the object may be used to control the amount of energy directed to the surface of the object. The optimal exposure time and energy content of the energy beam depends upon the chemical composition of the surface of the object, the shape of the surface of the object, the surface roughness of the object, the movement of the surface of the object relative to the beam, the angle the beam strikes the surface of the object, the type of laser being used, and on the ultimate application desired for the object being treated.

The preferred type of laser used in the invention depends on the specific application. Among the preferred lasers for metal and polymer surfaces is a Q-switched Nd : YAG laser. Among the preferred lasers for ceramic and polymer surfaces is a pulsed $CO_2$ laser. It is believed that an excimer laser is also preferred for metal, polymer and ceramic surfaces.

Generally when a longer pulse time laser is used, the amount of laser energy focused onto a given area per pulse needs to be increased. When using a laser having a pulse time between 1 and 10000 nanoseconds, the energy density of each laser pulse must be in the range of from 0.05 to 100 joules/$cm^2$, per pulse. When using a pulsed laser having a pulse time between 100 and 10,000 nanoseconds, preferably the energy density of each laser pulse is in the range of from 0.5 to 100 joules/$cm^2$ per pulse.

The determination of joules/$cm^2$ per pulse is made by interrelating two measurements. The first measurement is a determination of the specific laser beam energy per laser beam pulse. This measurement includes the use of a laser optical power meter as is well known in the art. Generally, laser power meters show the average power of the laser beam in average watts. The number of average watts reported by the laser power meter is divided by the number of laser beam pulses per second to obtain the number of joules per pulse. The pulse time is that time over which about 66 percent of the beam energy is emitted by the laser. The second measurement is a determination of the area on the surface to be modified that is impacted by the laser beam. This measurement is made by placing Zap-It brand laser thermal sensitive paper (Kentek Inc., Manchester, New Hampshire), or an equivalent paper, on the surface to be treated followed by examination of the resulting visible effect of a single laser pulse. An envelope is drawn around the visibly affected area of the pulse and the area of the envelope is calculated as is well known in the art of geometry. Finally, the number of joules per pulse is divided by the affected area in $cm^2$ to obtain the joules/$cm^2$ per pulse.

The method of the invention can be used for enhancing the adhesion performance between two surfaces, at least one of them being a metal, the other surface being formed of a material of a type capable of being treated with an energy beam to produce an enhanced bondable surface, such as in addition to a metallic sheet-forming surface, a polymer or a ceramic. Examples of such a surface include galvanized steel, an aluminum-containing material, or a magnesium-containing material. The method has been generally observed to enhance metallic surfaces in the tests conducted by the inventors without being limited to a particular metal.

In some applications it is desirable to modify only the metal surface for enhanced bonding. For example, when bonding dissimilar surfaces, one surface may require modification to enhance its performance to a level approximately equal to the other surface. Additionally, it is sometimes desirable to modify only one surface to predispose a bond to fail in a predictable and beneficial manner not unlike the desire for rolled cellophane adhesive tape to come off its roll with the adhesive layer bonded to only one side of the cellophane.

The invention can be used to bond different materials (one of them being metal) where both surfaces are treated. As an example, it is not generally possible to spot weld aluminum to steel while the present invention can be used to enhance the adhesive bonding of aluminum to steel, galvanized steel to glass fiber reinforced plastic (SMC), aluminum to SMC, and other dissimilar materials generally without limitation.

The specific adhesive used is not critical as long as said adhesive coacts with the modified surface to produce an enhanced bond. Preferred adhesives which work within the scope of the invention include urethanes, acrylics and epoxies. Other adhesives which work within the scope of the invention include silicone adhesives, cyanoacrylates and thermoplastic hot melts like polyimides. Alternatively, other hot melts, may work within the scope and teaching of the invention.

The specific curing conditions for the adhesive used are not critical. Generally, the curing conditions are recommended by the manufacturer of the adhesive for a given application. Preferably, the adhesive is applied to the modified surface with a minimum of delay in time. However, tests indicate that when a modified surface was kept covered (in a drawer), enhanced bonding performance was observed, even when the adhesive was applied one week and later after surface modification.

With respect to the temperature at which enhanced bonding is proved by lap shear or wedge testing, said testing is generally done at room temperature but can also be done at temperatures higher or lower than room temperature, e.g., at 82°C (180°F) or at −17.8°C (0°F).

With respect to the examples, the treated surface generally has appeared amenable to a wide variety of adhesives rather than appearing adhesive specific to particular adhesives.

Urethane based adhesives are well known and widely used to adhere plastic and/or metal adherends together. The choice of urethane adhesives over other adhesives is based in part upon their outstanding characteristics with respect to bond strength, chemical inertness, tensile strength and handling characteristics.

One component of a urethane based adhesive generally is an isocyanate-terminated prepolymer compound. Such a compound is normally prepared by reacting a polyisocyanate with a polyhydroxy compound or other compound containing labile hydrogen atoms that will give a positive Zerewitinoff test. The isocyanate group reacts with the labile hydrogen atom to form a urethane group. A molar excess of the isocyanate is added so that the resulting compound contains free isocyanate groups.

The other component of the urethane based adhesive is generally a cross-linking mixture comprising an admixture of polyhydroxy compound free of isocyanate groups and selected urethane catalysts. When the two components are admixed, for example, in a high shear mixing head and then applied to a surface, a reactive hydrogen can interact with a free isocyanate group chain extended and cross-linked with an isocyanate-terminated prepolymer to form a cured adhesive.

Other adhesives which work within the scope and teachings of the present invention include epoxy adhesives. A variety of epoxy adhesives work within the scope of the present invention including those which are rapidly curable at elevated temperatures and especially adapted for use on automotive assembly lines to adhesively bond metal and/or polymeric parts. Numerous types of epoxy adhesives exist on the market, such as the epoxy described in US- A-4,459,398 ; 4,467,071 ; and 4,485,229. Epoxies and epoxy resins which have increased adhesive strength contemplated for use within the present invention include epoxy resin formulations which are either pure or contain additives which enhance the properties of the epoxy resin. Exemplary enhanced epoxy resin compositions include those described in US-A-4,002,598 ; 4,011,281 ; 4,139,524 ; 4,146,701 ; 4,147,857 ; 4,178,426 ; and 4,219,638. Curable epoxy resins which are polymerized by ionic addition mechanisms and often require high curing temperatures and long setting times can be used within the scope and teachings of the invention. Essentially, any epoxy adhesive capable of forming a tight polymer network, characterized by durability, good adhesion, good water, chemical and/or heat-resistant qualities can be used within the scope of the invention.

Additionally, combinations of epoxies and acrylic based adhesives can be used. For example, the adhesive described in US-A-3,684,617 dealing with an adhesive mixture of acrylic based monomer and epoxy resin can be used within the scope of the invention. Also, a nonreactive composite adhesive described in US-A-3,994,764 may be used within the scope of the invention.

Acrylic adhesives can work within the scope and teachings of the present invention. Acrylic adhesives which include polymers and copolymers formed from acrylic and methacrylic acids and their derivatives can be applied to the laser treated surface and provide the enhanced bonding properties. It is anticipated that a variety of other adhesives will also have utility within the defined invention. These adhesives include carboxylic polymeric adhesives, polysulfide adhesives, phenolic resin adhesives, amino resin adhesives, ethylene copolymer based hot melt adhesives, polyvinyl acetal adhesives, anaerobic adhesives, polyamide adhesives and polyethylenimine based adhesives.

These adhesives can optionally contain other materials. Other optional ingredients which can be added to either component include thickeners, stabilizers, flame retardants, metal particles, fibers, fillers, thixotropes and the like. The adhesives which are usable within the scope and teachings of the present invention can be prepared by a variety of methods, e.g., one and/or two-part components using a variety of curing processes.

Adhesive materials can in some cases by used in conjunction with a primer as is well known in the art. Here such primers are considered to be adhesive materials.

The adhesive coating disposed on the surface of the material treated in accordance with the inventive

6

method, can form a more durable bond, as well as a stronger bond.

The invention can be carried out in alternative environments, such as a protective atmosphere composed of nitrogen, or alternatively, an environment containing an inert gas, such as argon or alternatively in an environment containing a reactive gas such as hydrogen. It is contemplated that the inventive method could be practiced in an atmosphere containing a mixture of gases which would enhance the treatment of the surface for enhanced bonding.

The novel features which are considered as characteristic of the invention are set forth in particular in the appended claims. The apparatus for the practice of the method, both as to its construction and its mode of operation, together with additional features and advantages of the method will be best understood upon perusal of the following detailed description of certain specific embodiments with reference to the accompanying drawings as shown in the following examples and comparative examples.

## Example 1

The apparatus for treating an object for enhanced adhesion includes a Q-switched Quanta-Ray Nd : YAG model no. DCR-2 laser. The laser produces radiation at a wavelength of 1.06 µm with a maximum average power of about 18 watts.

The laser beam is directed at the object to be treated by a system of optical components. The components route and focus the beam. The components are constructed of high quality quartz, S1-UV grade. The beam is directed by 90 degree prisms ESCO model no. 1125250 and focused to a line image about 12.7 mm (1/2 inch) long by a cylindrical 50 cm focal length lens, ESCO® model no. B1-20100.

The objects to be treated, 2.54 × 10.16 cm (1 × 4 inch) solvent cleaned (the term "solvent cleaned" in this and all examples herein means rinsing three times with methylene chloride unless otherwise indicated) 2024-T3 aluminum alloy panels 1.59 mm (1/16 of an inch) thick, are placed in a holder on a translation stage synchronized with the laser pulse repetition rate and translated through the beam. The translation apparatus includes a Velmex Unislide A4000 series translation stage. The slide of the translation apparatus is driven by a stepping motor from Superior Electric, model M061-FD08. The stepping motor is controlled by a Superior Electric model STM 103 controller and the controller is operated by a Commodore 64 computer for complex maneuvers or manually operated.

The panels are translated through the laser beam path at 18 mm/sec and the final 12.7 mm (1/2 inch) portion of each panel is treated. The lens to panel distance is 35 cm.

Four pairs of panels are treated at each of several energy density levels between 0.14 and 2.16 joules/cm$^2$ per pulse. Each panel pair is then bonded together applying a high strength two-part urethane adhesive cured at 135°C for 45 minutes (Dow XPR no. 0544-00923-05-1 urethane adhesive systems) containing 0.5 percent, 0.10 mm (0.004 inch)diameter glass beads to insure an evenly spaced "glue line" as is well known in the art, only to the treated portion of each panel with a 12.7 × 25.4 mm (1/2 × 1 inch) lap joint of the panel ends. Table I lists the lap shear strength (measured using ASTM test D-1002) of each panel pair so bonded in relation to laser energy density. The lap shear strength of the panels treated with 0.8 to 2.3 joules/cm$^2$ per pulse is about 50 percent higher than those with no treatment. The lap shear strength shown in Table I is an average of four tests and generally such tests show a statistical variation (relative standard deviation) of about ± 10 percent. Unless otherwise indicated, all examples herein involved testing in quadruplicate at any one laser energy density treatment.

7

## TABLE I

### LAP SHEAR TESTING OF LASER TREATED ALUMINUM
### PANELS BONDED TOGETHER WITH A URETHANE ADHESIVE

| Laser Energy Density, Joules/cm$^2$ per pulse | Lap Shear Strength, MN/m$^2$ (psi) |
|---|---|
| 0 | 15.86 (2,300) |
| 0.4 | 15.17 (2,200) |
| 0.6 | 17.23 (2,500) |
| 0.8 | 22.75 (3,300) |
| 1.0 | 26.20 (3,800) |
| 1.2 | 26.20 (3,800) |
| 1.7 | 24.13 (3,500) |
| 2.3 | 24.82 (3,600) |

Example 2

The apparatus of Example 1 is used in conjunction with 2.54 × 10.16 cm (1 × 4 inch) solvent cleaned magnesium panels 1.59 mm (1/16 inch) thick prepared as cold chamber die-cast magnesium alloys of type AZ 91B produced by The Dow Chemical Company. This alloy contains 9 percent aluminum and 1 percent zinc. The sample to lens distance is 25 cm.

The samples are moved through the beam at a rate of 15 mm/sec. These magnesium alloy panels are then bonded and tested as in Example 1. The results listed in Table II show that lap shear strength increases with increased laser energy density. The bond strength increases approximately 60 percent over that obtained from the untreated panels.

## TABLE II

### LAP SHEAR TESTING OF LASER TREATED MAGNESIUM
### PANELS BONDED TOGETHER WITH A URETHANE ADHESIVE

| Laser Energy Density, Joules/cm$^2$ per pulse | Lap Shear Strength, MN/m$^2$ (psi) |
|---|---|
| 0 | 8.27 (1,200) |
| 0.1 | 11.03 (1,600) |
| 0.3 | 11.72 (1,700) |
| 0.4 | 13.79 (2,000) |
| 0.8 | 12.41 (1,800) |
| 1.2 | 15.17 (2,200) |

Example 3

The apparatus of Example 1 is used in connection with 2.54 × 10.16 cm (1 × 4 inch) hot dip zinc galvanized steel panels (Deep DQSK, G-60 automotive grade) 0.77 mm (1/33 inch) thick. The panels are immersed in a water based oil emulsion, H. A. Montgomery no. DF-4285 and allowed to drain for a period of 15 to 45 minutes. The panels are translated through the laser beam at 7.4 mm/sec. The sample to lens distance was 50 cm.

These galvanized steel panels are then bonded and tested as in Example 1. The lap shear strength of the bonded panels versus the laser energy density is listed in Table III. Laser treatment in the energy density range of from 1.2 to 5.2 joules/cm$^2$ per pulse produced an increase in bond strength of almost an order of magnitude over that of the untreated material. As the laser power increases to 1.2 joules/cm$^2$ per pulse, the lap shear strength increases to about 13.79 MN/m$^2$ (2,000 psi) and remains at about that level for higher laser energy densities. The lap shear strength of non-oiled solvent cleaned panels of galvanized steel is about 8.96 MN/m$^2$ (1,300 psi).

## TABLE III

### LAP SHEAR TESTING OF LASER TREATED OILED GALVANIZED STEEL PANELS BONDED TOGETHER WITH A URETHANE ADHESIVE

| Laser Energy Density, Joules/cm$^2$ per pulse | Lap Shear Strength, MN/m$^2$ (psi) |
|---|---|
| 0 | 2.07 ( 300) |
| 1.2 | 6.98 (1,000) |
| 1.4 | 14.48 (2,100) |
| 1.9 | 11.72 (1,700) |
| 2.4 | 13.79 (2,000) |
| 2.8 | 13.10 (1,900) |
| 3.3 | 14.48 (2,100) |
| 5.2 | 13.79 (2,000) |

Example 4

The apparatus of Example 1 also can be used to improve the durability of bonding. Thirty-two sets of 4 hot dip zinc galvanized steel panels are first pretreated with an oil emulsion as in Example 3. Two of the panels of galvanized steel in each set are then translated through the laser beam at 7.4 mm/sec using a sample to lens distance of 50 cm and a laser energy density of approximately 1.60 joules/cm$^2$ per pulse. The other two panels of each set are not treated with the laser and instead are solvent cleaned to remove the oil. Table IV shows the bond strength of laser treated and solvent cleaned panels bonded together as in Example 1 versus the length of time the panels are exposed to a moist salty environment in a test known as the General Motors Scab Corrosion Test. This test is performed over a period of 32 days and involves testing the lap shear strength of the panels bonded as in Example 1. This experiment involves 32 cycles, where for each cycle, the bonded panels are placed for 22.5 hours in a cabinet with, relative humidity of 85 percent and a temperature of 63°C (145°F), followed by 0.25 hour immersion in a 5 weight percent NaCl solution in water and then 1.25 hours in a dry, room temperature area followed by a test of lap shear strength. After 7 cycles, the test results reveal that the untreated panels lost all lap shear strength and fell apart. In contrast, the laser treated panels maintain a bond for 32 days at a strength of at least 3.45-4.14 MN/m$^2$ (500-600 psi).

## TABLE IV

### BOND DURABILITY UPON EXPOSURE TO MOISTURE AND SALT FOR LASER TREATED AND SOLVENT CLEANED GALVANIZED STEEL PANELS

| Days of Exposure | Lap Shear Strength in MN/m² (psi) for the Solvent Cleaned Panels[a.] | Lap Shear Strength in MN/m² (psi) for the Laser Treated Panels[a.] |
|---|---|---|
| 0 | 8.96 (1,300) | 13.79 (2,000) |
| 1 | 4.14 ( 600) | 9.65 (1,400) |
| 4 | 4.14 ( 600) | 9.65 (1,400) |
| 7 | 0 | 8.96 (1,300) |
| 14 | 0 | 8.96 (1,300) |
| 18 | 0 | 6.21 ( 900) |
| 25 | 0 | 4.14 ( 600) |
| 28 | 0 | 3.45 ( 500) |
| 32 | 0 | 4.14 ( 600) |

[a.] Note, these data are the average of 2-3 determinations.

### Example 5

The apparatus of Example 1 is used in conjunction with hot dip zinc galvanized steel panels (Deep DQSK, G-60 automotive grade) and an acrylic adhesive. (Hardman red/white two-part acrylic adhesive, cured at 177°C (325°F) for 30 minutes). The galvanized steel panels are treated with an oil emulsion as in Example 3 prior to laser treatment. The sample to lens distance is 35 cm, the sample translation is 15 mm/sec through the laser beam and the laser energy density is 0.6 joules/cm² per pulse. The oily galvanized panels with no laser treatment before bonding have a bond strength of about 6.21 MN/m² (900 psi). The laser treated panels have a bond strength of approximately 11.03 MN/m² (1,600 psi). This result represents over a 75 percent increase in bond strength for the laser treated panels bonded with acrylic adhesive in comparison with untreated panels bonded with acrylic adhesive.

### Comparative Example 6

The apparatus of Example 1 is used in connection with treating 2.54 × 10.16 cm (1 × 4 inch) panels of sheet molding compound (calcium carbonate/glass fiber filled polyester resin containing zinc stearate as a mold release agent) 1.59 mm (1/16 inch) thick bonded with Hardman red/white two-part acrylic adhesive, containing 0.5 percent, 0.51 mm (0.020 inch) diameter glass beads, cured according to label directions. The panels are laser treated without any application of oil or other material to the surface of the panels. The lens to sample distance is 35 cm, the sample translation speed is 16 mm/sec and the laser energy density is 0.6 joules/cm² per pulse. Polymer panels bonded without laser treatment have bond strengths of about 0.69 MN/cm² (100 psi). The laser treated panels show a lap shear strength of about 3.45 MN/m² (500 psi). The increase in lap shear strength is greater than 500 percent for laser treated glass fiber filled polymer panels as compared to the untreated panels. Examination of the laser treated surface by x-ray photoelectron spectroscopy indicated that substantially all of the mold release agent was removed by the laser treatment as measured by the diminishment of zinc from the surface after laser treatment.

In addition, 2.54 × 10.16 cm (1 × 4 inch) panels of acrylonitrile-butadiene-styrene (ABS) plastic sheet, 1.59 mm (1/16 inch) thick, are laser treated as above and bonded with either a Dow two-part urethane adhesive as in Example 1 cured at 150°F for 30 minutes or bonded with Hardman red/white two-part acrylic adhesive cured at room temperature, containing 0.5 percent, 0.51 mm (0.020 inch) diameter glass beads, cured according to label directions. The lap shear strength of the laser treated panels is so high that the panels themselves break in testing at about a lap shear strength of 6.21 MN/m² (900 psi) and for comparison the lap shear strength of the panels without laser treatment is about 2.76 MN/m² (4OO psi).

## Example 7

In Examples 1-6 the test method is ASTM D-1002 for lap shear strength. In this example and in many of the following examples the test method is wedge test ASTM D-3762, modified as described below. In the modified ASTM D-3762 test, 2.54 × 10.16 cm (1 × 4 inch) metal panels 1.59 mm (1/16 inch) thick are bonded together with an adhesive and then a wedge is forced between the panels. The initial crack length is a function of several factors including the tensile strength of the bond. The bond strength can be so poor that the test panels fall apart, i.e., an initial crack length in excess of 7.62 cm (3 inches). After measuring the initial crack length, the wedged panels, with wedge in place, are placed in a 49°C, 100 percent relative humidity environment for 75 minutes and then the crack growth after exposure (herein termed "crack extension") is measured. If the bond has poor resistance to moisture, then the crack extension can be large and again if large enough the test panels can fall apart. The percent relative standard deviation precision of the wedge test is generally believed to be about ± 12 percent.

The system of Example 1 is used to laser treat solvent cleaned 2024-T3 aluminum alloy panels. The cylindrical lens is changed to one having a 25 cm focal length and the panels are placed 21 cm from this lens. Between the laser and the cylindrical lens is placed a polarizing filter. By adjusting the polarizing filter, different laser power can be directed upon the panels while operating the laser itself at full power (18 watts).

The panels are translated back and forth through the laser beam at 12 mm/sec to completely treat one side of each panel with about a 150 percent overlap of each pulse treated area. The treated surface of each panel is then coated with American Cyanamid epoxy primer no. BR-127, cured at 121°C (250°F) for 1 hour and bonded to an identically treated panel with 3 M epoxy adhesive no. AF-163-2, OST, Grade 5, cured at 121°C (250°F) for 1.5 hours under vacuum at 6.9 bar (100 psi) and wedge tested.

As listed in Table V, with no laser treatment the initial crack is about 37 mm and this crack grew about 30 mm upon exposure to moisture. At 0.7 to 1.6 joules/cm² of laser energy per pulse, the initial crack is significantly reduced and the crack grew only about 2 mm to about 5 mm upon exposure to moisture ; a significant improvement in both bond strength and bond durability upon exposure to moisture according to the wedge test.

## TABLE V

### WEDGE TESTING OF LASER TREATED ALUMINUM PANELS BONDED TOGETHER WITH AN EPOXY ADHESIVE

| Laser Energy Density, Joules/cm² per pulse | Initial Crack Length, mm | Crack Extension, mm |
|---|---|---|
| 0.0 | 37 | 30 |
| 0.7 | 12 | 5 |
| 0.8 | 12 | 2 |
| 1.1 | 13 | 2 |
| 1.4 | 12 | 2 |
| 1.6 | 12 | 2 |

## Comparative Example 8

This is a comparative example of several prior art surface preparation techniques. Panels of solvent cleaned 2024-T3 aluminum alloy are sanded with 80, 320 or 600 grit sandpaper (190, 29 and 17 µm, respectively), polished with 5 µm alumina, sandlasted with 54 grit aluminum oxide, or wire brushed with 320 µm (13 mil) wire. The soxhlet cleaned panels are placed in a Whatman LTD cellulose soxhlet thimble and soxhlet extracted with tol uene for 4 hours (~37 rinse cycles). The panel are then coated with American Cyanamid epoxy primer no. BR-127 and bonded together with 3 M epoxy adhesive no. AF-163-2 as in Example 7 and then wedge tested, see Table VI.

## TABLE VI

### WEDGE TESTING OF SEVERAL PRIOR ART SURFACE PREPARATION TECHNIQUES FOR ALUMINUM PANELS BONDED TOGETHER WITH AN EPOXY ADHESIVE

| Surface Treatment | Initial Crack Length | Crack Extension |
|---|---|---|
| 80 Grit Sandpaper | 24 mm | 21 mm |
| 320 Grit Sandpaper | 22 mm | 22 mm |
| 600 Grit Sandpaper | 17 mm | 15 mm |
| Polished Surface | 49 mm | >27 mm[a] |
| Sandblasted | 15 mm | 14 mm |
| Wire Brushed | 20 mm | 15 mm |
| Solvent Cleaned | 36 mm | >41 mm[a] |
| Soxhlet Cleaned | 30 mm | >47 mm[a] |

[a] Panels fell apart in the humidity cabinet.

The data in Table VI, when compared to the results obtained using the present invention, see Example 7, demonstrate the superiority of the present invention over the surface treatments listed in Table VI as indicated by the wedge test.

### Example 9

The system of Example 7 is used to again treat solvent cleaned 2024-T3 aluminum alloy panels except that the polarizing filter is removed and the laser power is adjusted as in Example 1. The panels are placed about 25 cm from the 25 cm focal length cylindrical lens.

The degree of overlap of the area covered by each laser pulse is about 150 percent., The pulse time of the laser depends on the power setting, being about 10 nanoseconds above 6 watts and from 10 to 40 nanoseconds between 1/2 watt and 6 watts,see Table VII.

## TABLE VII

### PULSE TIME OF THE LASER USED AS A FUNCTION OF ENERGY DENSITY AND OUTPUT POWER

| Laser Power in Watts/Sec | Laser Energy Density, Joules/cm² per pulse | Pulse Time in Nanoseconds |
|---|---|---|
| 0.5 | 0.7 | 40 |
| 1 | 0.8 | 25 |
| 2 | 1.1 | 20 |
| 3 | 1.4 | 16 |
| 4 | 1.6 | 12 |
| 5 | 1.9 | 11 |
| 6 | 2.2 | 10 |
| 10 | 3.3 | 10 |
| 15 | 4.7 | 10 |
| 18 | 5.5 | 10 |

The data in Table VII is provided to allow conversion from laser power to energy density and pulse time for the conditions described above. The following Table VIII shows example data of enhanced bonding characteristics.

The treated aluminum panels are then coated with American Cyanamid epoxy primer no. BR-127 and bonded together with 3 M epoxy adhesive no. AF-163-2 as in Example 7 and then wedge tested, see Table VIII.

## TABLE VIII

### WEDGE TESTING OF LASER TREATED ALUMINUM PANELS BONDED TOGETHER WITH AN EPOXY ADHESIVE

| Laser Energy Density, Joules/cm² per pulse | Initial Crack Length, mm | Crack Extension, mm |
|---|---|---|
| 0.0 | 40 | 30 |
| 0.7 | 19 | 20 |
| 0.8 | 12 | 1 |
| 1.1 | 12 | 1 |
| 1.4 | 11 | 1 |
| 1.9 | 12 | 1 |
| 2.7 | 11 | 3 |

The data in Table VIII indicate that even at a laser energy density of 0.7 joules/cm² per pulse, the bond strength and durability is improved relative to the nonlaser treated panels.

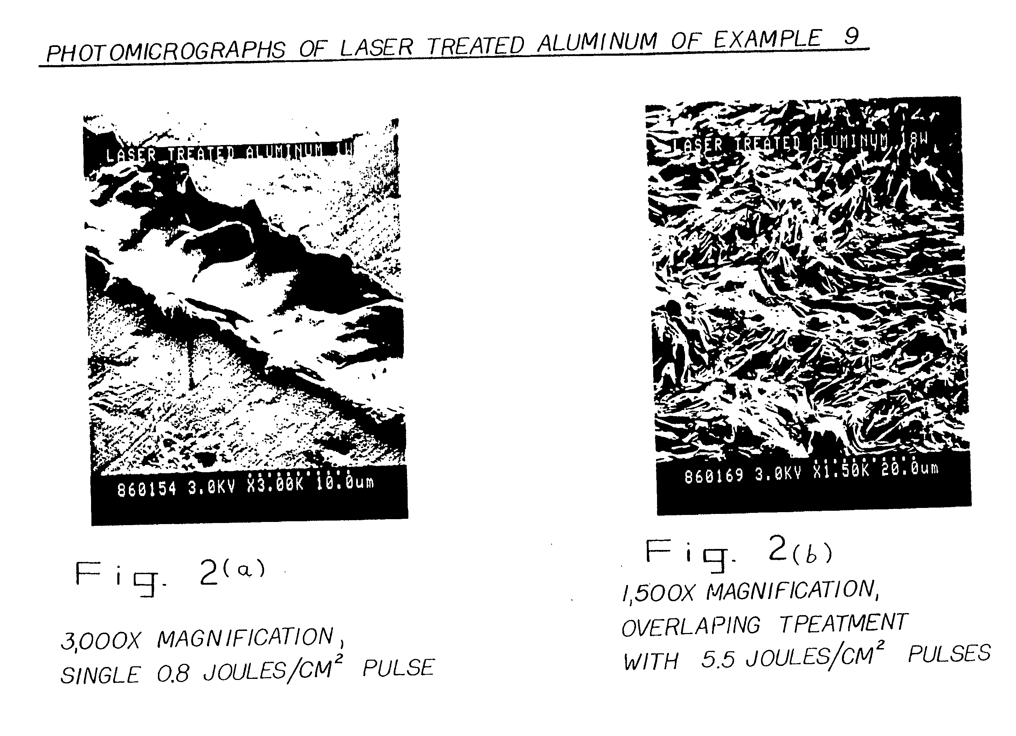

Figure 2 shows electron photomicrographs of aluminum treated with : (a) a single 0.8 joules/cm$^2$ pulse, shown at 3,000 X magnification ; and (b) an aluminum surface showing overlapping 2.7 joules/cm$^2$ pulses, shown at 1500 X magnification. These photomicrographs show evidence of surface vaporization and surface melting along with roughening of the surface. X-ray photoelectron spectroscopy of the treated surfaces listed in Table VIII indicates that even at 0.7 joules/cm$^2$ per pulse of laser energy density, the percent carbon on the surface of the aluminum is significantly diminished versus the untreated surface.

Optimization of economic factors using the invention can result from using full laser power with a defocused laser beam to treat a larger area of surface with each pulse. In this event, the linear velocity of relative movement between the laser beam and the surface to be treated can be higher and still effectively treat the surface for enhanced bonding characteristics.

## Example 10

The system of Example 9 is used to treat panels of solvent cleaned 304 grade stainless steel. The treated panels are then coated with American Cyanamid epoxy primer no. BR-127 and bonded together with 3 M epoxy adhesive no. AF-163-2 as in Example 7 and then wedge tested, see Table IX.

## TABLE IX

### WEDGE TESTING OF LASER TREATED STAINLESS STEEL PANELS BONDED TOGETHER WITH AN EPOXY ADHESIVE

| Laser Energy Density, Joules/cm$^2$ per pulse | Initial Crack Length, mm | Crack Extension, mm |
|---|---|---|
| 0 | 15 | 22 |
| 1.4 | 17 | 7 |
| 2.7 | 8 | 1 |
| 5.5 | 17 | 3 |

The data in Table IX show that optimum bond strength as indicated by initial crack length requires a specific treatment power range while bond durability as indicated by crack extension is improved at all laser power levels tested.

## Example 11

The system of Example 9 is used to treat panels of solvent cleaned hot dip zinc galvanized steel (Deep DQSK, G-60 automotive grade). The treated panels are then coated with American Cyanamid epoxy primer no. BR-127 and bonded together with 3 M epoxy adhesive no. AF-163-2 as in Example 7 and then wedge tested, see Table X.

## TABLE X

### WEDGE TESTING OF LASER TREATED GALVANIZED STEEL PANELS BONDED TOGETHER WITH AN EPOXY ADHESIVE

| Laser Energy Density, Joules/cm² per pulse | Initial Crack Length, mm | Crack Extension, mm |
|---|---|---|
| 0.0 | 11 | 2 |
| 1.4 | 2 | 0.3 |
| 2.7 | 2 | 0.2 |
| 5.5 | 4 | 0.3 |

The data in Table X show laser treatment improves both initial crack length and crack extension for galvanized steel under the conditions studied. However, it should be noted that the laser treated panels curled back upon wedge entry and thus the only conclusion believed to be shown by the data in Table X is that laser treatment improved bond strength.

X-ray photoelectron spectroscopy of the 0 and 1.4 joules/cm² per pulse treated panels indicates that before laser treatment the surface contains about 70 percent carbon, and that after treatment the surface is essentially 100 percent zinc oxide.

### Example 12

The system of Example 9 is used to treat panels of wire brushed and nonbrushed solvent cleaned Ti6A14 titanium alloy. The treated panels are then coated with American Cyanamid epoxy primer no. BR-127 and bonded together with 3 M epoxy adhesive no. AF-163-2 and then wedge tested, see Table XI.

## TABLE XI

### WEDGE TESTING OF LASER TREATED TITANIUM PANELS BONDED TOGETHER WITH AN EPOXY ADHESIVE

| Laser Energy Density, Joules/cm² per pulse | Initial Crack Length, mm | Crack Extension, mm |
|---|---|---|
| 0.0 | 24[a] | 36[a] |
| 0.0 | 20[b] | 8[b] |
| 1.4 | 20 | 4 |
| 2.7 | 22 | 4 |
| 5.5 | 24 | 11 |

[a] Not wire brushed.
[b] Wire brushed.

The data in Table XI show no improvement in bond strength at the laser powers tested as indicated by initial crack length. However, an improvement in bond durability is seen at 1.4 and 2.7 joules/cm² per pulse of laser energy as indicated by the crack extension data in Table XI.

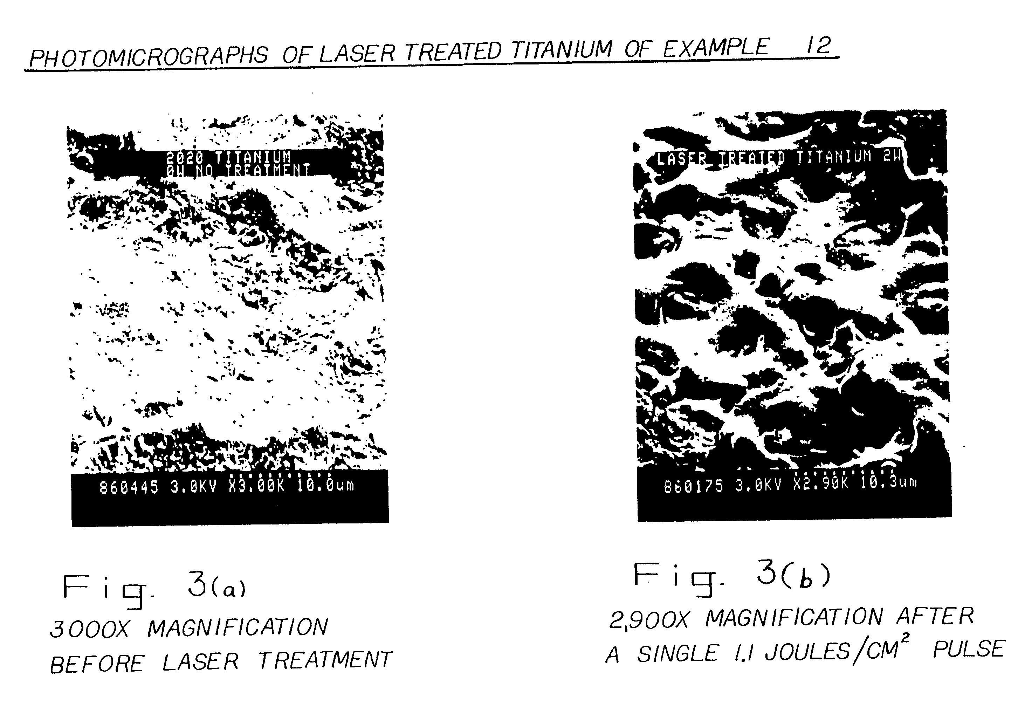

Figure 3 shows electron photomicrographs of : (a) the titanium alloy before laser treatment at 3,000 X magnification ; and (b) after laser treatment with a single 1.4 joules/cm$^2$ pulse at 2,900X magnification that also shows evidence of apparent surface melting.

X-ray photoelectron spectroscopy of the 0 and 3 watt treated panels indicates that before laser treatment the surface contains about 50 percent carbon and only about 2 percent titanium. After treatment the surface contains about 15 percent carbon and 19 percent titanium (present as titanium dioxide).

Example 13

The system of Example 9 is used to treat panels of solvent cleaned 0.381 μm (15 microinch)surface ground cold rolled steel. The treated panels are then coated with American Cyanamid epoxy primer no. BR-127 and bonded to an identically treated panel with 3 M epoxy adhesive no. AF-163-2 as in Example 7 and then wedge tested, see Table XII.

## TABLE XII

## WEDGE TESTING OF LASER TREATED COLD ROLLED STEEL PANELS BONDED TOGETHER WITH AN EPOXY ADHESIVE

| Laser Energy Density, Joules/cm$^2$ per pulse | Initial Crack Length, mm | Crack Extension, mm |
|---|---|---|
| 0 | 20 | 7 |
| 2.2 | 22 | 6 |
| 2.7 | 24 | 6 |
| 3.8 | 23 | 7 |
| 5.5 | 22 | 7 |

The data in Table XII show no significant improvement in either initial crack length or in crack extension under the conditions studied. When the solvent cleaned ground cold rolled steel panels are treated as listed in Table XII, bonded using a urethane adhesive as in Example 1 and subjected to the lap shear test, no significant improvement in lap shear strength results. Example 22 describes wedge testing of laser treated cold rolled steel panels and Example 28 describes lap shear testing of laser treated oily cold rolled steel panels.

Photomicrographs of the 5.5 joules/cm$^2$ per pulse laser treated ground steel surface showed a general smoothing of the surface, relative to the untreated ground surface, with evidence of overall apparent surface melting.

Example 14

The system of Example 9 is used to laser treat panels of solvent cleaned mirror smooth chrome plated steel. The treated panels are then coated with American Cyanamid epoxy primer no. BR-127 and bonded together with 3 M epoxy adhesive no. AF-163-2 as in Example 7 and then wedge tested, see Table XIII.

16

## TABLE XIII

### WEDGE TESTING OF LASER TREATED CHROME PLATED STEEL PANELS BONDED TOGETHER WITH AN EPOXY ADHESIVE

| Laser Energy Density, Joules/cm² per pulse | Initial Crack Length, mm | Crack Extension, mm |
|---|---|---|
| 0.0 | 45 | 13 |
| 0.8 | 6 | 0 |
| 1.4 | 6 | 0 |
| 2.7 | 14 | 3 |
| 5.5 | 16 | 6 |

The data in Table XIII show that under the conditions studied both bond strength and bond durability are improved by laser treatment as indicated by the wedge test.

### Example 15

The laser of Example 9 is replaced with an excimer laser having a wavelength of 0.249 µm, a pulse width of about 10 nanoseconds, a pulse frequency of 30 Hertz and a maximum power of 6 watts. The excimer laser is used to treat panels of aluminum, stainless steel and copper at a laser energy density of approximately 10 and 0 joules/cm² per pulse. The treated surface of each panel is then coated with American Cyanamid epoxy primer no. BR-127 and bonded to an identically treated panel of the same metal with 3 M epoxy adhesive no. AF-163-2 and then wedge tested. In each case, the laser treatment significantly enhances the bonding characteristics of the panels as indicated by the wedge test.

### Comparative Example 16

The system of Example 9 is used to treat panels of solvent cleaned 2024-T3 aluminum alloy panels. In this example the Q-switch of the laser is turned off and as a result the laser pulse length is about 100 microseconds. The cylindrical lens is replaced with a conventional converging lens and the laser pulse is focuse to a spot 0.6 mm in diameter on the object to be treated in order to compensate for the longer laser pulse length. The translation stage is controlled so that there is about 150 percent coverage of the panel surface with the laser pulses. The treated panels are then coated with American Cyanamid epoxy primer no. BR-127 and bonded to an identically treated panel with 3 M epoxy adhesive no. AF-163-2 as in Example 7 and then Wedge tested, see Table XIV.

## TABLE XIV

### WEDGE TESTING OF LASER TREATED ALUMINUM PANELS BONDED TOGETHER WITH AN EPOXY ADHESIVE

| Laser Energy Density, Joules/cm² per pulse | Initial Crack Length, mm | Crack Extension, mm |
|---|---|---|
| 0 | 37 | 39 |
| 140 | 30 | 48 |
| 210 | 15 | 10 |

The data in Table XIV indicate that significant enhancement of bond characteristics was observed at the highest laser power studied as indicated by the wedge test. This example demonstrates the use of a relatively long pulse length laser.

Comparing the data in Table XIV (Q-switch off) with the data in Table VII and Table VIII (Q-switch on) indicate that delivering a given laser energy density in a relatively short pulse (Q-switch on) is more efficient than a relatively long pulse (Q-switch off).

Example 17

The system of Example 9 is used to treat panels of solvent cleaned 2024-T3 aluminum alloy panels. The treated panels are then bonded together with Locktite Super Bonder 495 cyanoacrylate-type adhesive containing 0.5 percent, 0.10 mm (0.004 inch) diameter glass beads to insure an evenly spaced "glue line" as is well known in the art.

## TABLE XV

### WEDGE TESTING OF LASER TREATED ALUMINUM PANELS BONDED TOGETHER WITH A CYANOACRYLATE ADHESIVE

| Laser Energy Density, Joules/cm² per pulse | Initial Crack Length, mm | Crack Extension, mm |
|---|---|---|
| 0.0 | 54 | >23[a.] |
| 1.5 | 36 | 3 |

[a.] Panels fell apart in the humidity cabinet.

The data in Table XV show that both the initial crack length and crack extension are improved with the laser treatment.

Example 18

The system of Example 9 is used to treat panels of solvent cleaned, Bonderized, (phosphate treated) electrogalvanized steel. The treated panels are then coated with American Cyanamid epoxy primer no. BR-127 and bonded to an identically treated panel with 3 M epoxy adhesive no. AF-163-2 as in Example 7 and then wedge tested, see Table XVI.

## TABLE XVI

### WEDGE TESTING OF LASER TREATED
### BONDERIZED ELECTROGALVANIZED STEEL PANELS
### BONDED TOGETHER WITH AN EPOXY ADHESIVE

| Laser Energy Density, Joules/cm² per pulse | Initial Crack Length, mm | Crack Extension, mm |
|---|---|---|
| 0.0 | 8.0 | 2.2 |
| 0.8 | 7.6 | 0.7 |
| 1.4 | 8.1 | 0.0 |
| 2.7 | 8.2 | 0.0 |
| 5.5 | 6.7 | 0.4 |

The data in Table XVI indicate that although bond strength was not significantly improved by laser treatment as indicated by the initial crack length, bond durability was significantly improved as indicated by the crack extension under the conditions studied.

Comparative Example 19

The system of Example 9 is used to treat detergent washed panels of Duro Inc. 50A red silicone rubber. The test panels are not the usual 25.4 × 101.6 × 1.59 mm (1 × 4 × 1/16 inch), but rather are 25.4 × 101.6 × 3.18 mm (1 × 4 × 1/8 inch). The treated panels are then bonded together with 3 M Scotch®-Weld no. 2216 B/A flexible adhesive (3 parts "A" to 2 parts "B" by volume) cured 1 hour at room temperature and 1 hour at 82°C (180°F) and then subjected to the ASTM D-1876-72 peel test, see Table XVII.

## TABLE XVII

### PEEL TESTING OF LASER TREATED SILICONE RUBBER
### PANELS BONDED TOGETHER WITH SCOTCH-WELD ADHESIVE

| Laser Energy Density, Joules/cm² per pulse | Peel Strength N/cm (Pounds per Linear Inch) |
|---|---|
| 0.0 | 0.175 ( 0.1) |
| 1.35 | 14.53 ( 8.3) |
| 5.5 | 23.81 (13.6) |

The data in Table XVII indicate that the bond strength as indicated by the peel test was significantly improved after laser treatment.

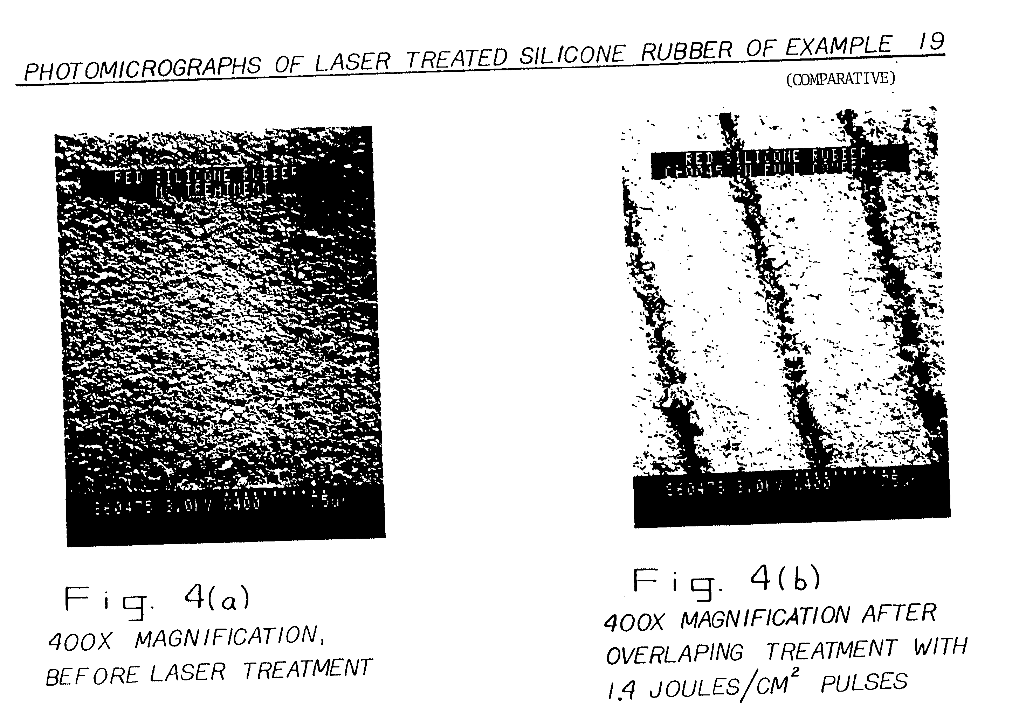

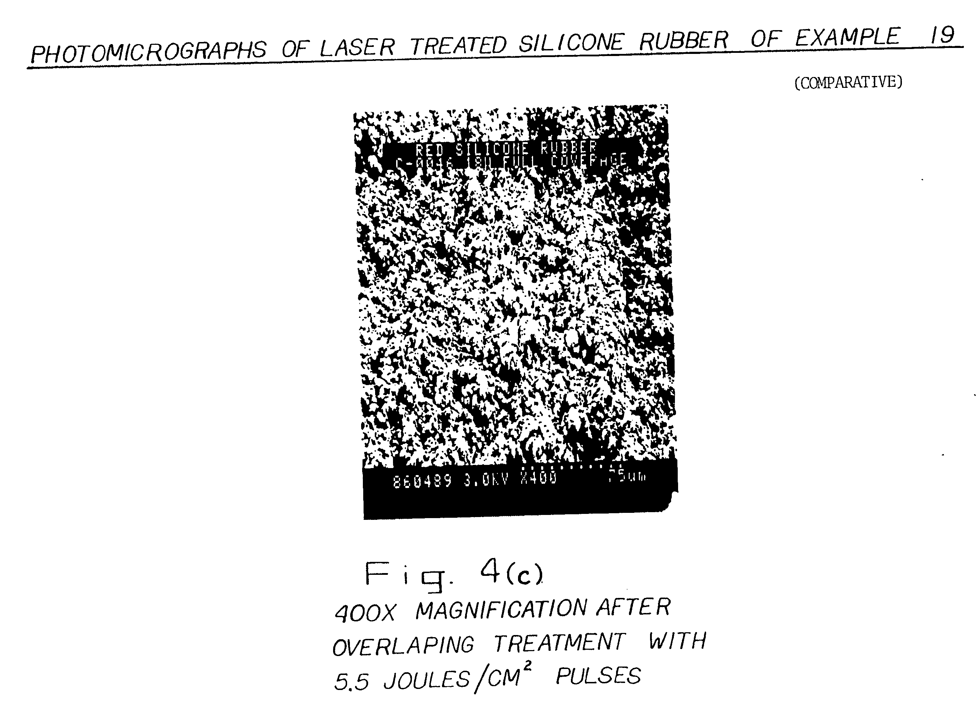

Figure 4 shows 400X magnification electron photomicrographs of silicone rubber : (a) before laser treatment ; (b) after overall treatment with 1.4 joules/cm² per pulse of laser energy ; and (c) after overall treatment with 5.5 joules/cm² per pulse of laser energy. Figure 4 shows evidence of apparent surface vaporization. Figure 4(c) shows evidence of general overall apparent surface vaporization and roughening.

Example 20

The system of Example 9 is used to laser treat panels of solvent cleaned pure tin. The treated panels are then coated with American Cyanamid epoxy primer no. BR-127 and bonded together with 3 M epoxy adhesive no. AF-163-2 as in Example 7 and then peel tested using the ASTM 1876-72 peel test, see Table XVIII.

## TABLE XVIII

### PEEL TESTING OF LASER TREATED TIN PANELS BONDED TOGETHER WITH AN EPOXY ADHESIVE

| Laser Energy Density, Joules/cm² per pulse | Peel Strength, N/cm (Pounds per Linear Inch) |
|---|---|
| 0 | 6.304 (3.6) |
| 1.4 | 15.58 (8.9) |
| 2.7 | 12.25 (7.0) |
| 5.5 | 6.13 (3.5) |

The data in Table XVIII show that at the intermediate laser energy densities per pulse, the peel strength is significantly improved relative to no laser treatment.

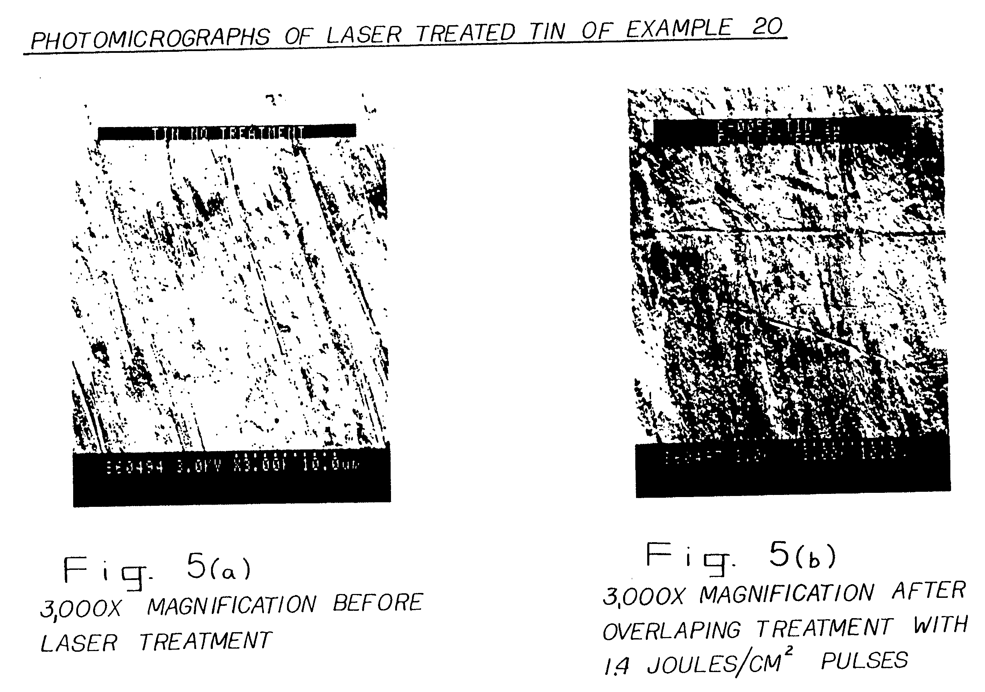

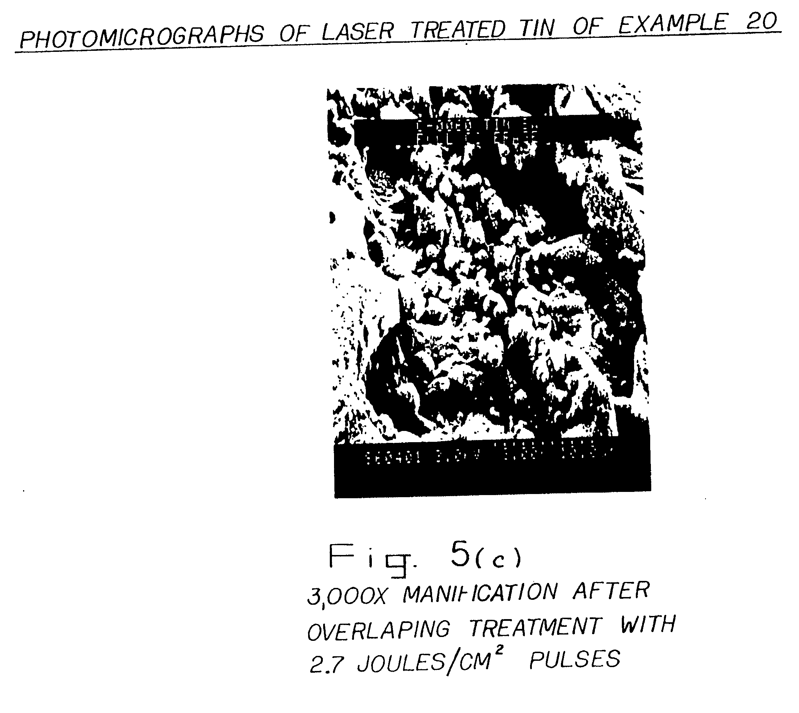

Figure 5 shows 3,000X magnification electron photomicrographs of tin : (a) before laser treatment ; (b) after overlapping treatment with 1.4 joules/cm² laser pulses ; and (c) after overlapping treatment with 2.7 joules/cm² laser pulses. Although there is no significant apparent difference between Figure 5(a) and 5(b), the data in Table XVIII indicates that the surface shown in Figure 5(b) was apparently beneficially modified even though there is no apparent surface melting and roughening of the type shown in Figure 3(b) or Figure 2(a). Figure 5(c) does show evidence of apparent surface melting and vaporization.

Comparative Example 21

The system of Example 9 is used to laser treat panels of solvent cleaned aircraft grade graphite fiber reinforced epoxy composite panels 101.6 × 25.4 × 1.01 mm (4 × 1 × 0.040 inches), (60 volume percent Bercules IM-6 graphite fibers, 40 volume percent epoxy resin). The treated panels are bonded together with Hardman blue/beige urethane adhesive, containing 0.5 percent, 0.51 mm (0.020 inch) glass spheres, and tested for lap shear strength using the ASTM D-1002 lap shear test. Another set of treated panels are bonded together with Hardman yellow epoxy adhesive containing 0.5 percent, 0.51 mm (0.020 inch) diameter glass spheres, and tested for lap shear strength using the same test. The test results are shown in Table XIX.

## TABLE XIX

### LAP SHEAR TESTING OF LASER TREATED GRAPHITE FIBER REINFORCED EPOXY COMPOSITE PANELS BONDED TOGETHER WITH A URETHANE ADHESIVE OR AN EPOXY ADHESIVE

| Laser Energy Density, Joules/cm² per pulse | Lap Shear Strength, MN/m² (psi) Urethane Adhesive | Lap Shear Strength, MN/m² (psi) Epoxy Adhesive |
|---|---|---|
| 0.0 | 19.3 (2,800) | 12.7 (1,845) |
| 1.4 | 20.8 (3,020) | -- |
| 5.5 | 20.8 (3,010) | 16.2 (2,350) |

The data in Table XIX indicate that the laser treatment resulted in stronger bonds as indicated by the lap shear test for both adhesives at all laser energy densities per pulse studied but with a signficant improvement in lap shear strength shown only for the epoxy adhesive. Using the urethane adhesive without laser treatment shows most of the bond failure at the interface between the adhesive and the panel, whereas with laser treatment the bond failure occurred mostly in the adhesive. Therefore, it is believed that the use of a stronger urethane adhesive would have resulted in even higher lap shear test results than shown in Table XIX.

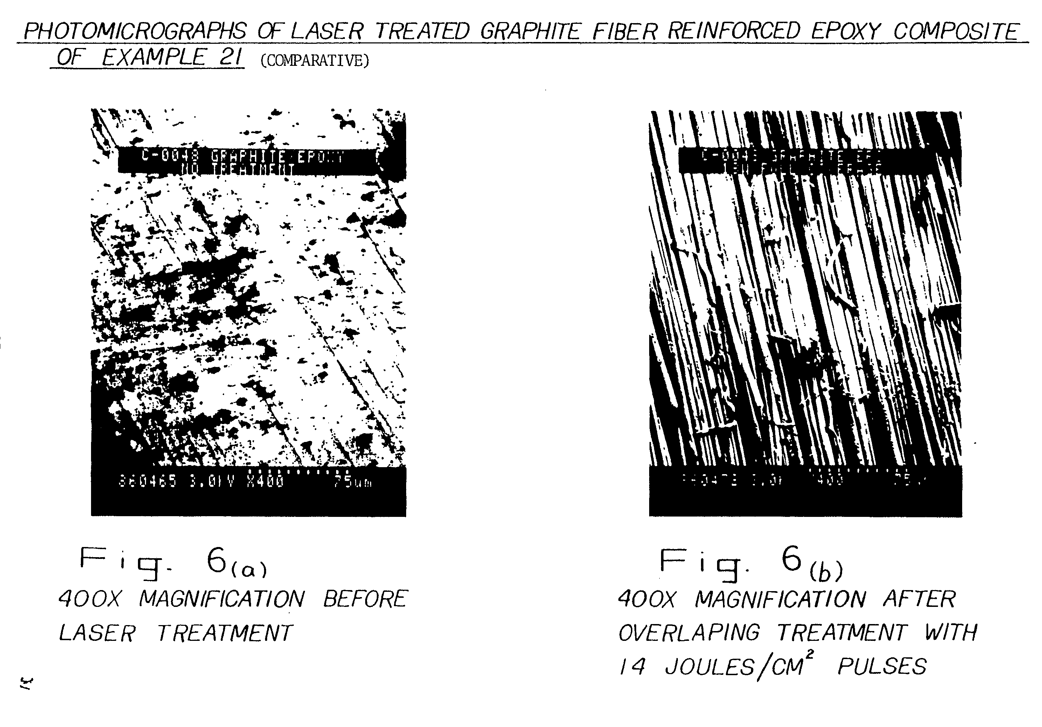

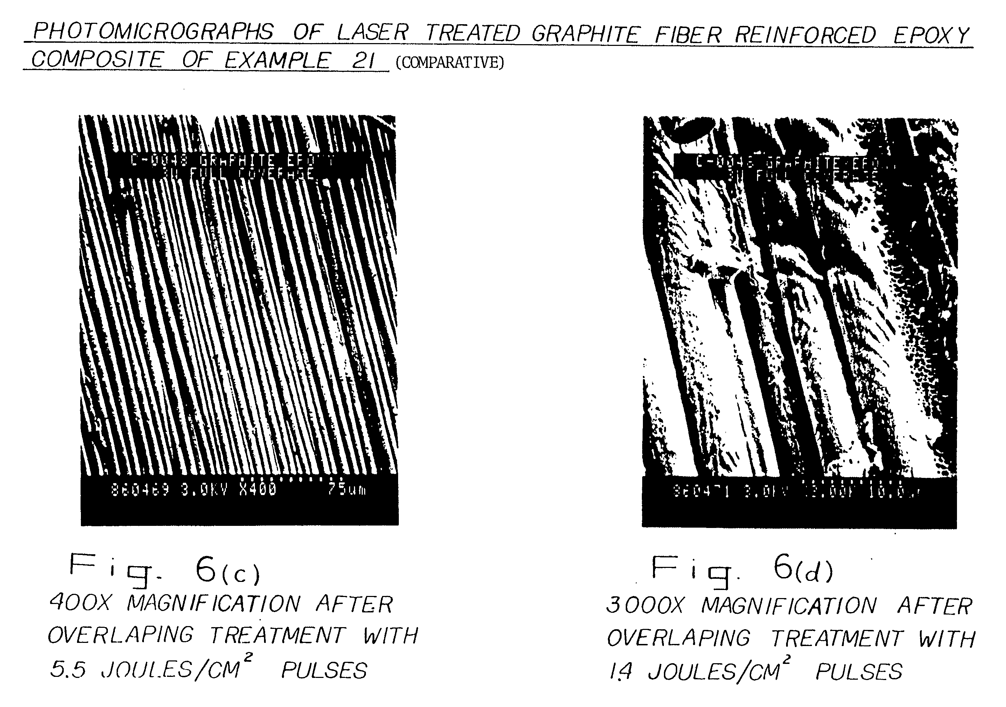

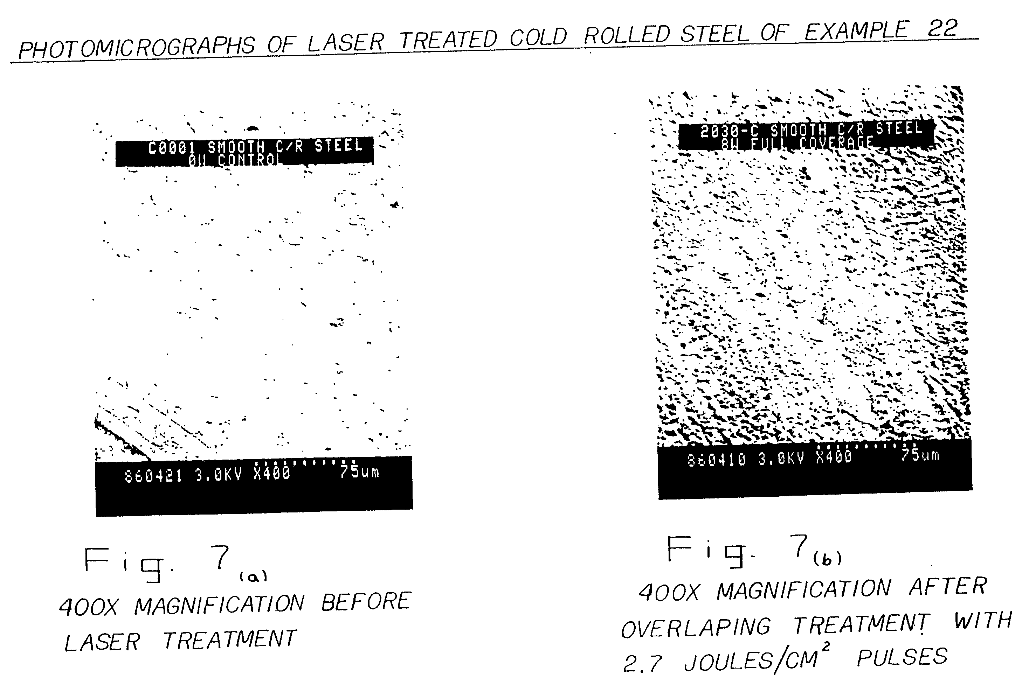

Figure 6 shows electron photomicrographs of the graphite fiber reinforced epoxy composite panels : (a) before laser treatment at 400X magnification ; (b) after overlapping treatment with 1.4 joules/cm² pulses at 400X magnification ; (c) after overlapping treatment with 5.5 joules/cm² pulses at 400X magnification ; and (d) the same treatment as (b) above but at 3,000X magnification.

Figure 6(a) shows the graphite fibers just under the surface of the epoxy resin. Figure 6(b) shows the exposure of the fibers, apparently due to vaporization of the epoxy resin around the fibers. Figure 6(c) shows in addition to the exposure of the fibers some apparent fiber damage that nevertheless does not appear to detract from bonding performance.

### Example 22

The system of Example 9 is used to laser treat panels of solvent cleaned mill finish cold rolled steel (surface not ground). The treated panels are then coated with American Cyanamid epoxy primer no. BR-127 and bonded together with 3 M epoxy adhesive no. AF-163-2 as in Example 7 and then wedge tested, see Table XX.

## TABLE XX

### WEDGE TESTING OF LASER TREATED COLD ROLLED STEEL PANELS BONDED TOGETHER WITH AN EPOXY ADHESIVE

| Laser Energy Density, Joules/cm² per pulse | Initial Crack Length, mm | Crack Extension, mm |
|---|---|---|
| 0.0 | 26 | 24 |
| 0.8 | 13 | 2 |
| 1.4 | 12 | 1 |
| 2.7 | 12 | 2 |
| 5.5 | 11 | 4 |

The data in Table XX indicate that the laser treatments studied resulted in stronger and more durable bonds as indicated by the wedge test relative to no laser treatment.

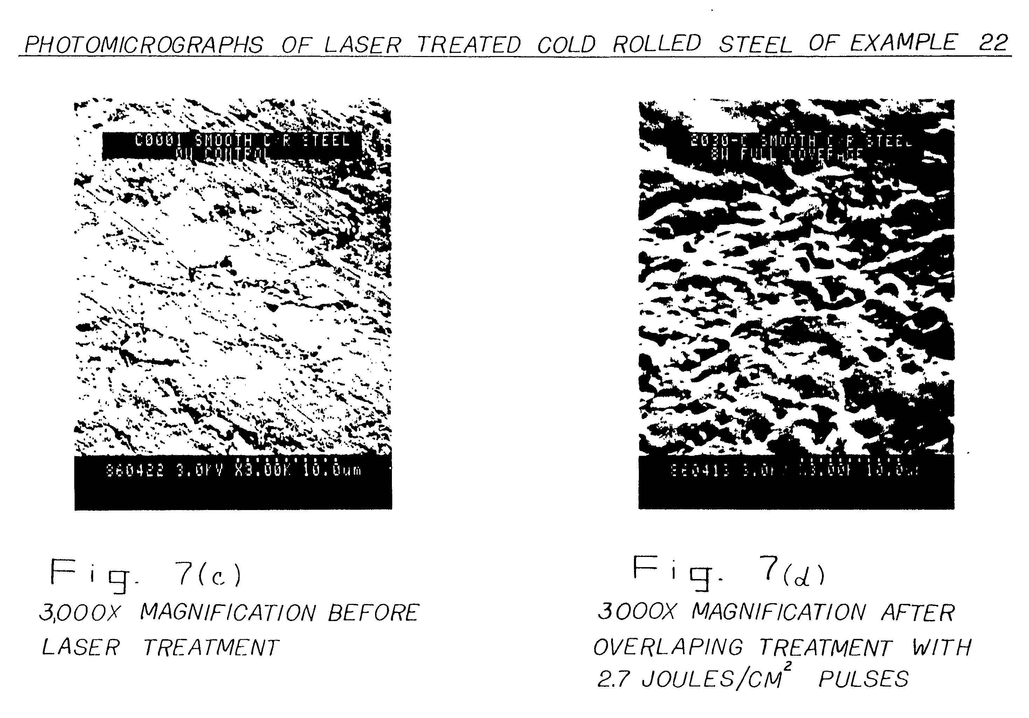

Figure 7 shows electron photomicrographs of the steel panels : (a) before laser treatment at 400X ; (b) after treatment with overlapping 2.7 joules/cm² pulses at 400X ; (c) before laser treatment at 3,000X magnification; and (d) after treatment with overlapping 2.7 joules/cm² pulses at 3,000X magnification. Figure 7(b) and (d) show apparent surface melting and roughening unlike the surface discussed in Example 13 and it is believed that the roughening shown in Figure 7(b) and (d) may be partly responsible for the improved performance shown in Table XXI with laser treatment.

Example 23

The system of Example 9 is used to treat panels of solvent cleaned copper. In this example the panels are 3.18 mm (1/8 inch) thick instead of the more usual 1.59 mm (1/16 inch) thickness. The treated 2.54 × 10.16 cm (1 × 4 inch) panels are then coated with American Cyanamid epoxy primer no. BR-127 and bonded to an identically treated panel with 3 M epoxy adhesive no. AF-163-2 as in Example 7 and then wedge tested, see Table XXI.

## TABLE XXI

### WEDGE TESTING OF LASER TREATED COPPER
### PANELS BONDED TOGETHER WITH AN EPOXY ADHESIVE

| Laser Energy Density, Joules/cm² per pulse | Initial Crack Length, mm | Crack Extension, mm |
|---|---|---|
| 0 | 43 | 20 |
| 1.4 | 47 | 3 |
| 2.7 | 30 | 8 |
| 5.5 | 47 | 12 |

The data in Table XXI show that optimum bond strength as indicated by initial crack length requires a specific power range while bond durability as indicated by crack extension is improved at all laser power levels tested. In the wedge test, low yield strength materials such as copper require thicker panels (than the usual 1.59 mm (1/16 inch) thick panels) to prevent the panels from simply curling back as the wedge is inserted between the bonded panels.

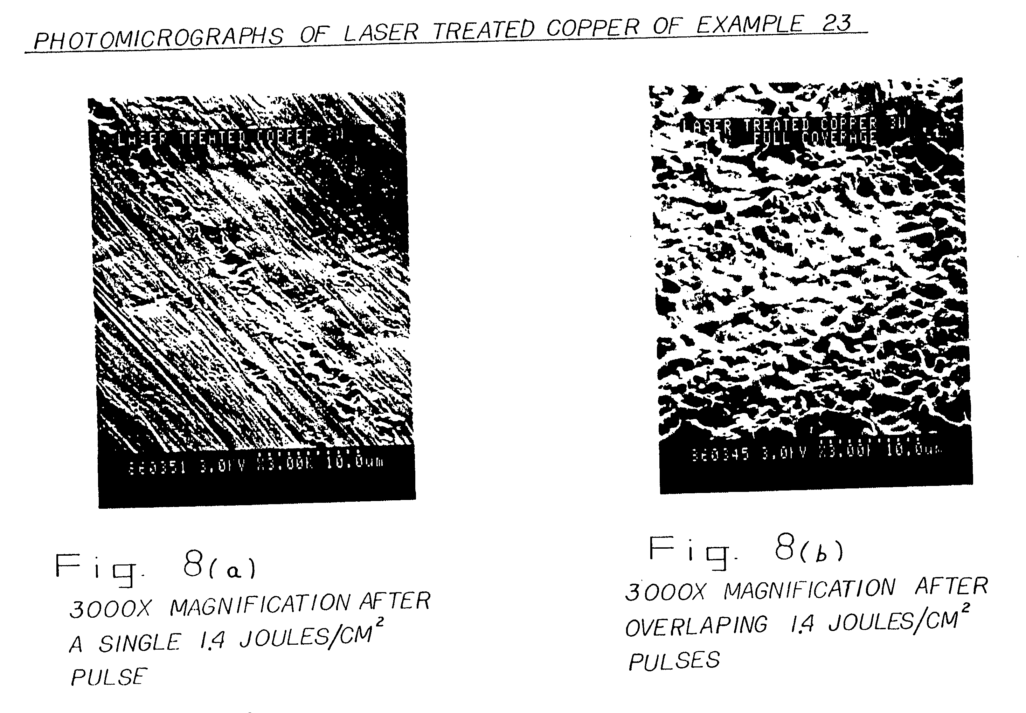

Figure 8 shows 3,000X magnification electron photomicrographs of the copper panels : (a) after laser treatment with a single 1.4 joules/cm² pulse ; and (b) after laser treatment with overlapping 1.4 joules/cm² pulses. Figure 8(a) and (b) show apparent surface melting and roughening after laser treatment.

Example 24

The system of Example 9 is used to laser treat panels of solvent cleaned pure molybdenum. The treated panels are then coated with American Cyanamid epoxy primer no. BR-127 and bonded together with 3 M epoxy adhesive no. AF-163-2 as in Example 7 and then wedge tested, see Table XXII.

## TABLE XXII

### WEDGE TESTING OF LASER TREATED MOLYBDENUM PANELS BONDED TOGETHER WITH AN EPOXY ADHESIVE

| Laser Energy Density, Joules/cm² per pulse | Initial Crack Length, mm | Crack Extension, mm |
|---|---|---|
| 0.0 | 48 | a. |
| 1.4 | 23 | a. |
| 2.7 | 35 | a. |

a. Panels fell apart in the humidity cabinet.

The data in Table XXII indicate an optimum in bond strength enhancement at an energy density of 1.4 joules/cm² per pulse under the conditions studied as indicated by the initial crack length of the wedge test.

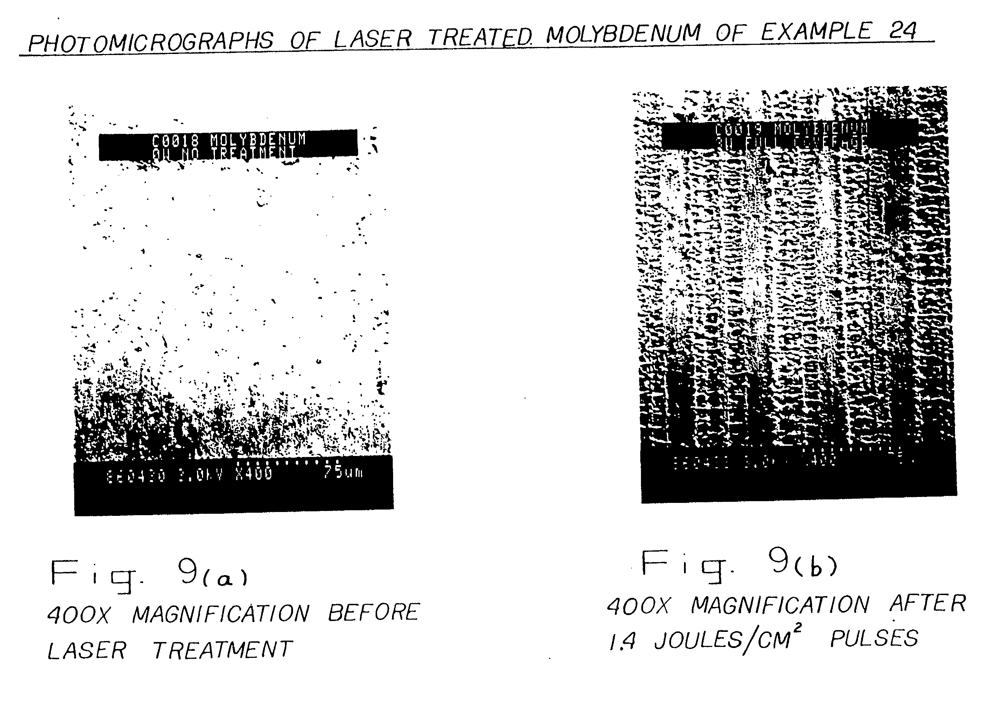

Figure 9 shows 400X magnification electron photomicrographs of the molybdenum panels : (a) before laser treatment ; and (b) after laser treatment with 1.4 joules/cm² pulses. Figure 9(b) shows apparent surface melting and roughening after laser treatment.

### Example 25

The system of Example 9 is used to laser treat panels of solvent cleaned pure tungsten. The treated panels are then coated with American Cyanamid epoxy primer no. BR-127 and bonded together with 3 M epoxy adhesive no. AF-163-2 as in Example 7 and then wedge tested, see Table XXIII.

## TABLE XXIII

### WEDGE TESTING OF LASER TREATED TUNGSTEN PANELS BONDED TOGETHER WITH AN EPOXY ADHESIVE

| Laser Energy Density, Joules/cm² per pulse | Initial Crack Length, mm | Crack Extension, mm |
|---|---|---|
| 0.0 | 62 | a. |
| 2.7 | 47 | a. |

a. Panels fell apart in the humidity cabinet.

The data in Table XXIII indicate almost exactly a 25 percent reduction in initial crack length after laser treatment.

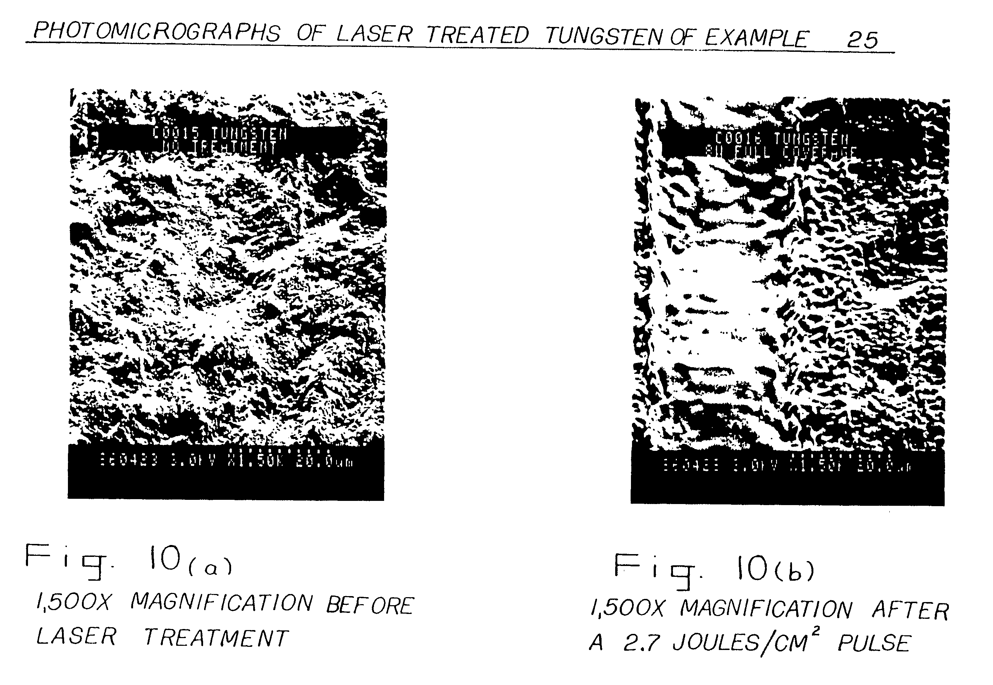

Figure 10 shows 1,500X magnification electron photomicrographs of the tungsten panels : (a) before laser treatment ; and (b) after a single 2.7 joules/cm² pulse. Figure 10(b) shows apparent surface melting and roughening after laser treatment.

### Example 26

The system of Example 9 is used to treat 0.15 mm (0.006 inch) thick solvent cleaned aluminum foil panels. The treated panels are bonded together with Dow Corning Silastic® 732 RTV adhesive cured at room tem-

23

perature for 3 days at 70 percent relative humidity or with 3 M Scotch Weld 2216 B/A epoxy adhesive cured for 1 hour at room temperature and 1 hour at 82°C (180°F) both containing 0.5 percent, 0.10 (0.004 inch) diameter glass spheres, and then peel tested, see Table XXIV.

## TABLE XXIV

### PEEL TESTING OF LASER TREATED ALUMINUM FOIL BONDED TOGETHER WITH A SILICONE ADHESIVE OR AN EPOXY ADHESIVE

| Laser Energy Density, Joules/cm² per pulse | Peel Strength, N/cm (Pounds per Linear (Inch)), Silicone Adhesive | Peel Strenght, N/cm (Pounds per Linear 25,4 mm (inch)), Epoxy Adhesive |
|---|---|---|
| 0.0 | 0.350 (0.2) | 14.009 ( 8.0) |
| 1.4 | 12.608 (7.2) | 24.166 (13.8) |

The data in Table XXIV show that laser treatment significantly improves bond strength as indicated by the peel test for both adhesives tested.

### Example 27

The system of Example 9 is used to treat 1.4 mm (0.055 inch) thick panels of solvent cleaned Ti6Al4 titanium alloy with overlapping 1.4 joules/cm² pulses.

The panels are bonded together with Langley Research Center Thermoplastic Polyimide primer and adhesive resin and tested for lap shear strength. The primer coated panels are cured for 1 hour at 163°C (325°F) prior to applying the adhesive to the panels which is heated for 1.5 hours at 328°C (625°F) under vaccum at 13.8 bar (200 psi) to bond the panels together. For comparison, additional panels are chromic acid anodized according to aircraft industry standards and bonded together and tested as above. Of all the prior art treatments for titanium alloy, the chromic acid anodizing process is often preferred despite waste disposal considerations for the spent chromic acid bath liquors. The comparative data is shown in Table XXV.

## TABLE XXV

### LAP SHEAR TESTING OF LASER TREATED TITANIUM PANELS AND CHROMIC ACID ANODIZED TITANIUM PANELS BONDED TOGETHER WITH A THERMOPLASTIC POLYIMIDE ADHESIVE

| Treatment | Lap Shear Strength, MN/m² (psi) |
|---|---|
| Laser | 31.9 (4,640) |
| Anodized | 30.5  4,430 |

The data in Table XXV show that the laser treatment provides a stronger bond than the anodizing treatment but not a significantly stronger bond. Importantly, the data show that the present invention approximately equals the best of the prior treatments for titanium alloy with regard to lap shear testing without a problem of waste disposal of spent bath liquors.

Example 28

The system of Example 1 is used to laser treat panels of oiled cold rolled steel. The panels are bonded together with a urethane adhesive as in Example 1 and then tested for lap shear strength, see Table XXVI.

## TABLE XXVI

## LAP SHEAR TESTING OF LASER TREATED OILY COLD ROLLED STEEL PANELS BONDED TOGETHER WITH A URETHANE ADHESIVE

| Laser Energy Density, Joules/cm$^2$ per pulse | Lap Shear Strength, MN/m$^2$ (psi) |
|---|---|
| 0.0 | 15.17 (2,200) |
| 0.8 | 17.24 (2,500) |
| 1.1 | 24.82 (3,600) |
| 1.4 | 28.96 (4,200) |
| 1.6 | 37.92 (5,500) |
| 1.9 | 28.96 (4,200) |
| 2.2 | 35.85 (5,200) |
| 2.7 | 34.47 (5,000) |
| 3.3 | 28.96 (4,200) |
| 4.0 | 22.06 (3,200) |

The data in Table XXVI indicate that above a laser power density of about 1 joule/cm$^2$, a significant improvement in bond strength is observed with an apparent optimum in improvement around 2 joules/cm$^2$. The lap shear strength of solvent cleaned and nonlaser treated panels is about 31.03 MN/m$^2$ (4,500 psi). Therefore, the improvements in bond strength shown in Table XXVI are believed to be at least partly attributed to a vaporization of the oil from the surface of the steel with the laser treatment.

Example 29

The system of Example 9 is used to laser treat panels of 2024-T3 aluminum at a laser energy density of 1.4 joules/cm$^2$ per pulse. The panels are bonded together (12 × 25 mm 1/2 × 1 inch overlap of the ends of the panels as in a lap shear test) with Hardman "blue/beige" two-part urethane adhesive, containing 0.5 percent, 0.1 mm (0.004 inch) diameter glass beads cured for 1 hour at room temperature and then at 250°F (121°C) for 1 hour. The bonded panels are then impact tested by General Motors side impact test (modified from the ASTM D-256-81 impact test) wherein the pendulum impact head strikes at right angles to the bond. The bonded panels show an average impact strength of more then 6.778 N·M (5 foot pounds). Nonlaser treated panels bonded as above show an average impact strength of 0.542 N·M (0.4 foot pounds).

Example 30

The system of Example 9 is used to laser treat 12.7 × 101.6 × 0.56 mm (1/2 × 4 × 0.022 inch) panels of gold clad Kovar alloy at a laser energy density of 1.4 joules/cm$^2$ per pulse. The gold thickness is 0.064 mm (0.0025 inches) (24 carat gold). The laser treated gold surface of the panels are bonded together with Dow Corning Silastic RTV-732 silicone adhesive containing 0.5 percent, 0.51 mm (0.020 inch) diameter glass spheres and allowed to cure for 2 days at room temperature and peel tested at a crosshead speed of (2 inches) per minute. The peel strength is 98.21 kg per linear mm (5.5 pounds per linear inch). Without laser treatment bumt bonding as above, the peel strength is 35.7 kg per linear mm (2.0 pounds per linear inch).

Comparative Example 31

A Gentec Model DD-250 TEA $CO_2$ laser is focused with a spherical ZnSe lens of focal length 100 mm to achieve the energy density indicated in Table XXVII. The pulse length of this laser has a peak including approximately 50 percent of the energy of 0.1 microsecond in length. The remainder of the energy is included in a tail approximately 1.0 microsecond in length. The results in Table XXVII indicate no improvement in initial crack, durability, or mode of failure with laser treatment of approximately 5 joules/cm² per pulse.

## TABLE XXVII

| Material | Laser Energy Density, Joules/cm² per pulse | Initial Crack Length, mm | Crack Extension, mm |
|---|---|---|---|
| Aluminum | 0 | 36.1 | 34.5 |
| | 5.2 | 34.8 | 42 |
| Cold Rolled Steel | 0 | 40 | 8.5 |
| | 5.2 | 40 | 7.6 |

**Claims**

1. A method for enhancing the bonding characteristics of an adhesive between two surfaces wherein one of them is a metal surface by modifying at least the metal surface with an energy beam generated by a pulsed laser to generate a roughened surface having load-bearing structures **characterized in that** the energy beam has a pulse time between 1 and 10000 ns and the energy density is between 0.05 and 100 Joules/cm² per pulse to melt and vaporize the surface and to control the depth of any melting or charring of the surface material.

2. The method of Claim 1, wherein surfaces of different materials are bonded and both surfaces are treated.

3. The method Claims 1 or 2, wherein the second surface is a polymer

4. The method of Claims 1 to 3, wherein the second surface is a metal.

5. The method of Claims 1 to 3, wherein the second surface is an inorganic material

6. An article comprising an adhesive bond between at least two surfaces of said article prepared by a method according to any of claims 1 to 5.

**Ansprüche**

1. Verfahren zum Erhöhen der Hafteigenschaften eines Klebstoffes zwischen zwei Oberflächen, von denen eine eine Metalloberfläche ist, durch Verändern mindestens der Metalloberfläche mit einem von einem Impulslaser erzeugten Energiestrahl, um eine aufgerauhte Oberfläche mit tragendem Gefüge zu schaffen, **dadurch gekennzeichnet,** daß der Energiestrahl eine Impulsdauer zwischen 1 und 10.000 ns und eine Energiedichte von zwischen 0,05 und 100 Joule/cm² pro Impuls aufweist, um die Oberfläche zu schmelzen und zu verdampfen und um die Tiefe jeglichen Schmelzens oder Verbrennens des Oberflächenmaterials zu steuern.

2. Verfahren nach Anspruch 1, **dadurch gekennzeichnet,** daß die Oberflächen unterschiedlicher Materialien verbunden und beide Oberflächen behandelt werden.

3. Verfahren nach Ansprüchen 1 oder 2, **dadurch gekennzeichnet,** daß die zweite Oberfläche ein Polymer ist.

4. Verfahren nach Ansprüchen 1 bis 3, **dadurch gekennzeichnet,** daß die zweite Oberfläche ein Metall ist.

5. Verfahren nach Ansprüchen 1 bis 3, **dadurch gekennzeichnet,** daß die zweite Oberfläche ein anorganisches Material ist.

6. Gegenstand mit einer Klebbindung zwischen mindestens zwei Oberflächen des Gegenstandes, hergestellt durch ein Verfahren nach jedem der Ansprüche 1 bis 5.

## Revendications

1. Procédé pour renforcer les caractéristiques d'adhésivité d'une colle entre deux surfaces, dont l'une est une surface métallique, en modifiant au moins la surface métallique à l'aide d'un faisceau d'énergie produit par un laser pulsé pour créer une surface plus rugueuse ayant des structures porteuses de charges, caractérisé en ce que le faisceau d'énergie a une durée d'impulsions comprise entre 1 et 10000 ns et la densité d'énergie est comprise entre 0,05 et 100 joules/cm$^2$ par impulsion pour fondre et vaporiser la surface et régler la profondeur de toute fusion ou combustion de la matière superficielle.

2. Procédé selon la revendication 1, dans lequel des surfaces de matières différentes sont collées, et les deux surfaces sont traitées.

3. Procédé selon la revendication 1 ou 2, dans lequel est seconde surface est en polymère.

4. Procédé selon les revendications 1 à 3, dans lequel la seconde surface est en métal.

5. Procédé selon les revendications 1 à 3, dans lequel la seconde surface est en matière inorganique.

6. Objet comportant une liaison par colle entre au moins deux surfaces dudit objet, préparées à l'aide d'un procédé selon l'une quelconque des revendications 1 à 5.

# Fig. 1

Fig. 2(a)

3,000X MAGNIFICATION,
SINGLE 0.8 JOULES/CM² PULSE

Fig. 2(b)

1,500X MAGNIFICATION,
OVERLAPING TREATMENT
WITH 5.5 JOULES/CM² PULSES

EP 0 229 159 B1

Fig. 3(a)

3000X MAGNIFICATION
BEFORE LASER TREATMENT

Fig. 3(b)

2,900X MAGNIFICATION AFTER
A SINGLE 1.1 JOULES/$CM^2$ PULSE

EP 0 229 159 B1

PHOTOMICROGRAPHS OF LASER TREATED SILICONE RUBBER OF EXAMPLE 19

(COMPARATIVE)

Fig. 4(a)

400X MAGNIFICATION,
BEFORE LASER TREATMENT

Fig. 4(b)

400X MAGNIFICATION AFTER
OVERLAPING TREATMENT WITH
1.4 JOULES/CM$^2$ PULSES

EP 0 229 159 B1

(COMPARATIVE)

Fig. 4(c)

400X MAGNIFICATION AFTER
OVERLAPING TREATMENT WITH
5.5 JOULES/$CM^2$ PULSES

EP 0 229 159 B1

Fig. 5(a)

3,000X MAGNIFICATION BEFORE
LASER TREATMENT

Fig. 5(b)

3,000X MAGNIFICATION AFTER
OVERLAPING TREATMENT WITH
14 JOULES/CM$^2$ PULSES

EP 0 229 159 B1

PHOTOMICROGRAPHS OF LASER TREATED TiN OF EXAMPLE 20

Fig. 5(c)

3,000X MANIFICATION AFTER
OVERLAPING TREATMENT WITH
2.7 JOULES/CM$^2$ PULSES

EP 0 229 159 B1

PHOTOMICROGRAPHS OF LASER TREATED GRAPHITE FIBER REINFORCED EPOXY COMPOSITE
OF EXAMPLE 21 (COMPARATIVE)

Fig. 6(a)
400X MAGNIFICATION BEFORE
LASER TREATMENT

Fig. 6(b)
400X MAGNIFICATION AFTER
OVERLAPING TREATMENT WITH
14 JOULES/CM$^2$ PULSES

Fig. 6(c)
400X MAGNIFICATION AFTER
OVERLAPING TREATMENT WITH
5.5 JOULES/CM² PULSES

Fig. 6(d)
3000X MAGNIFICATION AFTER
OVERLAPING TREATMENT WITH
14 JOULES/CM² PULSES

EP 0 229 159 B1

Fig. 7 (a)

400X MAGNIFICATION BEFORE
LASER TREATMENT

Fig. 7 (b)

400X MAGNIFICATION AFTER
OVERLAPING TREATMENT WITH
2.7 JOULES/CM$^2$ PULSES

Fig. 7(c)

3,000X MAGNIFICATION BEFORE
LASER TREATMENT

Fig. 7(d)

3000X MAGNIFICATION AFTER
OVERLAPING TREATMENT WITH
2.7 JOULES/CM$^2$ PULSES

EP 0 229 159 B1

Fig. 8(a)

3000X MAGNIFICATION AFTER A SINGLE 1.4 JOULES/CM$^2$ PULSE

Fig. 8(b)

3000X MAGNIFICATION AFTER OVERLAPING 1.4 JOULES/CM$^2$ PULSES

EP 0 229 159 B1

Fig. 9(a)

400X MAGNIFICATION BEFORE
LASER TREATMENT

Fig. 9(b)

400X MAGNIFICATION AFTER
1.4 JOULES/CM$^2$ PULSES

Fig. 10 (a)

1,500X MAGNIFICATION BEFORE LASER TREATMENT

Fig. 10 (b)

1,500X MAGNIFICATION AFTER A 2.7 JOULES/$CM^2$ PULSE

EP 0 229 159 B1